(19) Europäisches Patentamt / European Patent Office / Office européen des brevets

(11) EP 2 553 011 B1

(12) EUROPEAN PATENT SPECIFICATION

(45) Date of publication and mention of the grant of the patent:
**31.12.2014 Bulletin 2015/01**

(21) Application number: **11712804.1**

(22) Date of filing: **25.03.2011**

(51) Int Cl.:
***C08K 9/02*** $^{(2006.01)}$ ***C08K 9/08*** $^{(2006.01)}$

(86) International application number:
**PCT/EP2011/054657**

(87) International publication number:
**WO 2011/117410 (29.09.2011 Gazette 2011/39)**

# (54) POLYMER COMPOSITIONS COMPRISING CORE/SHELL PARTICLES

POLYMERZUSAMMENSETZUNG MIT KERN-/SCHALEPARTIKEL

COMPOSITIONS DE POLYMÈRECOMPRENANT DES PARTICULES DE COEUR/ENVELOPPE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.03.2010 EP 10157972**

(43) Date of publication of application:
**06.02.2013 Bulletin 2013/06**

(73) Proprietor: **SOLVAY SA**
**1120 Bruxelles (BE)**

(72) Inventors:
- **GAUTHY, Fernand**
  **B-1780 Wemmel (BE)**
- **MILTNER, Hans, Edouard**
  **B-1050 Brussels (BE)**
- **TONIOLO, Paolo**
  **I-20020 Cesate (IT)**

(74) Representative: **Vande Gucht, Anne et al**
**Solvay S.A.**
**Département de la Propriété Industrielle**
**Rue de Ransbeek, 310**
**1120 Bruxelles (BE)**

(56) References cited:
**WO-A1-03/104319 WO-A1-2008/019905**

- **DATABASE CAPLUS, [Online] 15 October 2003 (2003-10-15), ISHII NOBUAKI ET AL: "Aqueous slurry containing silica-coated zinc oxide particles for polymer composition", XP002595381, retrieved from CAPLUS Database accession no. 2003-805890 cited in the application -& WO 2009/157302 A1 (KONICA MINOLTA HOLDINGS INC [JP]; KIMURA AKIYOSHI [JP]) 30 December 2009 (2009-12-30)**
- **KIMURA AKIYOSHI: "Ion-conductive composition for electrochemical device, contains core-shell particles whose surface contains ion-conductive compound", WPI / THOMSON,, vol. 2010, no. 4, 30 December 2009 (2009-12-30), XP002595472, -& JP 2003 292818 A (SHOWA DENKO KK) 15 October 2003 (2003-10-15)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 553 011 B1

## Description

CROSS REFERENCE TO RELATED APPLICATIONS

This application claims priority to European application No. 10157972.0 filed on March 26, 2010, the whole content of this application being incorporated herein by reference for all purposes.

The present invention relates to polymer compositions comprising certain polymers and core/shell particles of a specific structure and composition.

WO 2008/019905 relates to zinc/silicon oxide particles and to a method for their preparation. The particles are used in dispersions, in coating compositions and in sunscreen formulations. The particles have a core/shell structure, the core consisting essentially of zinc oxide and a shell consisting essentially of silicon dioxide. The molar ratio of Zn to Si is in the range of from 2 to 75. When used as UV absorbers in polymer compositions, the property spectrum of the final product is not fully satisfactory.

JP 2003/0292818 relates to core/shell $ZnO/SiO_2$ particles having an average diameter of from 5 to 200 nm, the core consisting essentially of ZnO having an average diameter of from 5 to 100 nm. The particles are described as fillers for polymer compositions. There is no indication on an influence of the Zn/Si molar ratio on the properties of the polymer compositions, in particular of compositions comprising high temperature resistant polymers.

JP 2002/182424 discloses nanoparticulate core/shell particles of various types but there is no indication of an influence of the molar ratio of the core metal to the shell metal on the properties of polymeric compositions comprising the said core/shell particles.

DE 101 31 173 and DE 101 64 904 relate to methods for the preparation of core shell particles comprising a core of nanoparticulate inorganic oxides and a shell of inorganic oxides/hydroxides. No information is given on molar ratios of core metal to shell metal atoms.

US 7 371 275 discloses coated titanium dioxide particles and their use in polymer compositions, in particular compositions comprising PVC as polymers. The silica content (silica is the preferred shell) is in the range of from 1.2 to 10 % by weight of the core shell particles which corresponds to a molar ratio of Ti to Si in the range of from approximately 4 to 30. There is no indication to the use of the particles in polymer compositions comprising high temperature resistant polymers.

US 2003/186634 discloses in example 6 a core/shell particle comprising $TiO_2$ as core and $SiO_2$ as a shell wherein the core has a diameter of 10 nm and the shell has a diameter of 21 nm. The molar ratio of Ti to Si in these particles can be calculated as 0.05:1.

WO 2003/104319 relates to powders comprising silica coated zinc oxide and the use of such powders in organic polymer compositions. The atomic ratio of Zn to Si which can be calculated from the data given in some of the examples is higher than 3, which leads to not fully satisfactory properties in particular when incorporating such powers in high temperature resistant polymers. The silica coated particles are treated with a hydrophobicity imparting agent.

From the foregoing it becomes apparent that there is still a need for polymer compositions comprising core/shell particles which provide fully satisfactory results, in particular in terms of dispersibility, homogeneous distribution of the core/shell particles in the polymer matrix and, where applicable, transparency of the compositions.

The object of the present invention was to provide polymer compositions comprising the aforesaid components and which have improved overall properties.

This object is achieved through polymer compositions comprising

a) at least 10 wt%, based on the combined weight of components a) and b), of a polymer selected from the group consisting of polyarylene polyethers having recurring units of the general formula I

$$\{X_1\text{-}(E\text{-}(A)_o)_n\text{-}(X_2)_r\text{-}(E'\text{-}(A')_p)_m\} \qquad \text{(I)}$$

wherein

$X_1$ is -O- or -S-,
$X_2$ is -O- or -S-
E and E' are the same or different and represent arylene groups containing 6 to 24 carbon atoms,
A and A' are the same or different and represent a mono-substituted 1,4-phenylene of the general formula

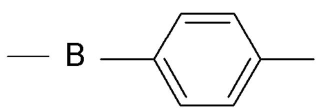

wherein B is O, S, $CH_2$, $C(CH_3)_2$, $C(CF_3)_2$, $SO_2$ or CO,
n and m are independently an integer of from 1 to 3,
o and p are 0, 1 or 2, and
r is 0 or 1,
polyimides comprising recurring units including at least one or more aromatic ring and one or more imide groups II as such or in their amic acid form II'

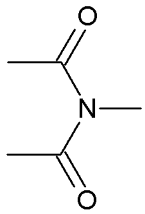

(II)

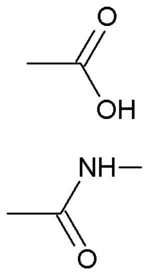

(II')

or halogenated polymers or mixtures thereof, and

b) 0.1 wt% to 100 wt%, based on the weight of a), of at least one core/shell particle comprising

b1) at least one core comprising at least one inorganic compound C1 comprising at least one metal M1, and
b2) a shell comprising at least one inorganic compound C2 comprising at least one metal M2
wherein
the compounds C1 are, independently from compounds C2, selected from the group of oxides, oxyfluorides, oxyhydroxyfluorides and mixtures thereof,
the compounds C2 are selected from the group consisting of oxides, fluorides, oxyfluorides and oxyhydroxyfluorides,
the metal M1 is selected from the group consisting of Zn, Ti, Zr, Ce or mixtures thereof,
the metal M2 is selected from the group consisting of Si, Mg, Ca, Sr and mixtures thereof,
the molar ratio of the metal M1 in the core to the metal M2 in the shell is in the range of from 0.1:1 to 1.7:1, and
the average particle diameter of the core/shell particles is less than or equal to 300 nm.

Preferred polymer compositions in accordance with the invention are set forth in the dependent claims and in the detailed specification hereinafter.

As a result of the intensive studies carried out in connection with the instant invention it has been surprisingly found that the molar ratio of the core metal atom to the shell metal atom in the core/shell particles b) has an influence on the final properties of polymer compositions comprising such particles.

Polyarylene polyethers having recurring units of formula I are known to the skilled man and available as commercial products in a wide variety.

A first preferred group of polymers of formula I is referred to hereinafter as poly(arylether sulfone)s, which for the purpose of this invention are intended to cover polymers of formula I wherein at least 5 % of the recurring units (RU) are derived from one or more formulae comprising at least one arylene group, at least one ether group (-O-) and at least one sulfone group ($-SO_2-$). A first preferred group of poly(arylether sulfone)s comprises recurring units of formula Ia

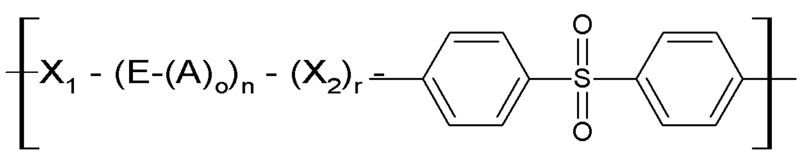

(Ia)

wherein the variables have the meaning as defined hereinbefore for formula I.

Preferably the poly(arylether sulfone)s comprise at least 50, preferably at least 75, preferably at least 90 and more preferably at least 95 % of recurring units as defined above. Most preferably the poly(arylether sulfone) contains such recurring units, in particular recurring units of formula Ia as sole recurring units.

Poly(arylether sulfone)s are often obtained by polycondensation, in particular by polycondensation of at least one dihalodiphenyl sulfone with at least one diol (dihydroxy monomer).

According to certain embodiments suitable poly(arylether sulfone)s comprise recurring units $(PhSO_2Ph)_k$ linked through ether or thioether units and where k is in the range of from 1 to 3 or can be fractional in this range. Preferably poly(arylether sulfones)s of this type comprise in addition recurring units $(Ph)_l$ so linked, where I is in the range of from 1 to 3 and can be fractional in this range and such groups Ph are linked linearly through a single chemical bond or a divalent group other than $-SO_2-$, such as, but not limited to -CO- or are fused together. Ph represents phenylene, in particular p-phenylene (or 1,4-phenylene). By "fractional" reference is made to the average value for a given polymer chain containing units having various values of k or I.

In some embodiments poly(arylether sulfone)s have relative proportions of $(PhSO_2Ph)_k$ and $(Ph)_l$ such that on average at least two units of the first type are in immediate mutual succession in each polymer chain present and the two units are preferably present in a ratio of from 1:99 to 99:1, especially of from 10:90 to 90:10. Typically the polymers contain 25 -50 % of recurring units $(Ph)_l$ the balance being formed by the unit $(PhSO_2Ph)_k$.

In some particular examples of poly(arylether sulfone)s the recurring units may comprise recurring units where two groups $PhSO_2Ph$ are linked through ether or thioether groups (sulphur and oxygen may differ from unit to unit) to units $(Ph)_l$. If both of these units are present, their ratio is preferably between 10:90 and 80:20, more preferably between 10:90 and 55:45.

Another possibility to characterize poly(arylether sulfone)s is to express the weight percent content of $SO_2$, defined as 100 x (weight of $SO_2$/ weight of average repeat unit).

Calculated in accordance with this formula, the preferred $SO_2$ content is at least 12 %, preferably in the range of from 13 to 32 %.

Particularly advantageously the poly(arylether sulfone)s may be synthesized by polycondensation of 4,4'-dichlorodiphenylsulfone with the desired co-monomers to yield the desired polymer recurring units.

A preferred group of co-monomers for the copolymerization with 4,4'-dichlorodiphenylsulfone is indicated in the following table as dihydroxy monomers

**Table 1**

| | |
|---|---|
| 4,4'-dihydroxydiphenyl oxide | 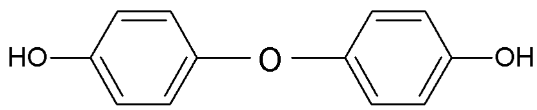 |
| 4,4'-dihydroxydiphenylsulfide | 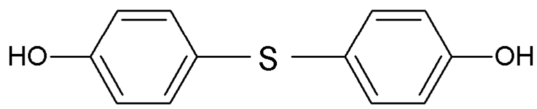 |
| 4,4'-dihydroxydiphenylmethane | 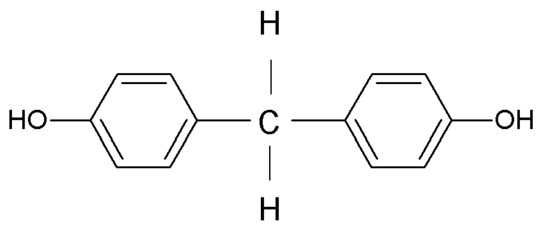 |
| 2,2'-bis(p-hydroxyphenyl)propane (Bisphenol A) | 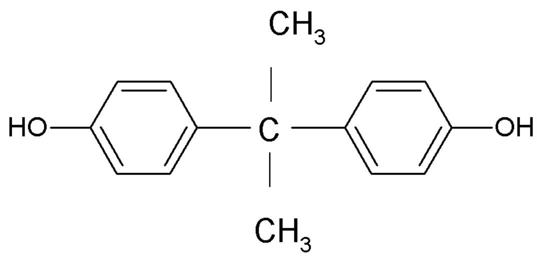 |

(continued)

| | |
|---|---|
| 2,2'-bis(p-hydroxyphenyl)perfluoropropane | 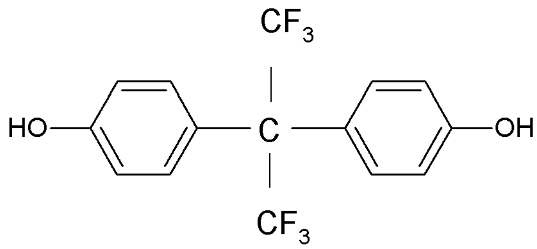 |
| 4,4'-dihydroxybenzophenone | 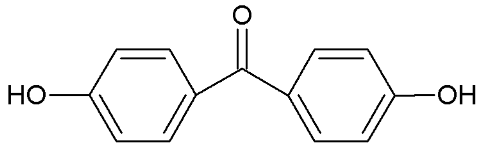 |
| 4,4'-dihydroxydiphenylsulfone | 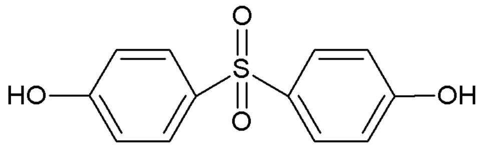 |
| Hydroquinone | 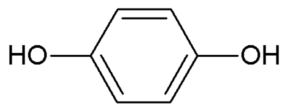 |
| 4,4-dihydroxydiphenyl | 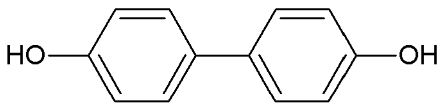 |
| 1,4-bis(4-hydroxyphenyl)benzene | 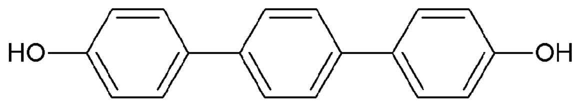 |

2,2'-Bis(p-hydroxyphenyl)propane (also frequently referred to as Bisphenol A) and 4,4'-dihydroxydiphenylsulfone and mixtures thereof are a first group of particularly preferred comonomers from the above table, yielding products commonly referred to as PSU and PES and commercially available i.a. from Solvay Advanced Polymers under the tradenames Udel® and Veradel®.

A further preferred monomer is 4,4'-bis(4"-hydroxybenzenesulfonyl)diphenyl of formula

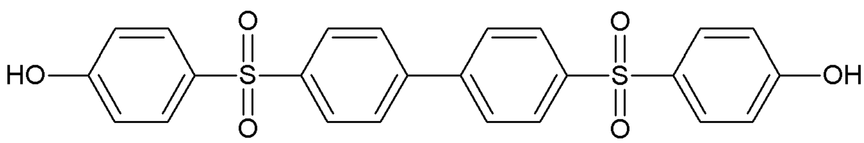

In all the foregoing monomers the hydroxy groups can in principle be substituted by SH-groups, thus yielding the respective polyarylene polythioethers.

Alternatively, poly(arylether sulfone)s may be obtained through nucleophilic synthesis from halophenols or halothiophenols.

In any nucleophilic synthesis, the halogen may be activated by a suitable catalyst, e.g. a copper catalyst. In case where the halogen is activated by an electron withdrawing group the use of a catalyst can often be dispensed with. Fluorine compounds are generally more active than chlorine compounds.

The nucleophilic synthesis is preferably carried out in the presence of one or more alkali metal carbonates in a slight molar excess, preferably in the range of up to 10 mole% over the stoichiometric amount, and in an aromatic sulfone solvent. The temperature of the reaction is generally in the range of from 150 to 350 °C.

Illustrative examples of processes for the manufacture of poly(arylether sulfone)s and examples of respective polymers are described in US Patents No. 4,065,437; 4,108,837; 4,175,175; 4,839,435; 5,434,224 and 6,229,970, which

are incorporated herein by reference.

The molecular weight of the poly(arylether sulfone)s can be in any range enabling the practical processing by e.g. injection moulding, extrusion, sheet forming etc. under melt or thermoforming conditions to provide moulded, formed and/or extruded articles having the desired physical, mechanical and optical properties.

Preferably the number average molecular weight is in the range of from about 2,000 to about 60,000. Number average molecular weights of at least 9,000, preferably at least 10,000, e.g. in a range of from 9,000 to 35 000 and preferably in the range of from 11,000 to 35,000 are preferred. However, for certain applications the molecular weight may be lower, e.g. in the range of from 3,000 to 11,000, preferably in the range of from 3,000 to 9,000. The molecular weight can be determined by gel permeation chromatography using dichloromethane as a solvent and polystyrene calibration standards in accordance with ASTM D-5296-05.

The melt flow rate of the poly(arylether sulfone)s is preferably low, e.g. in the range of from 2 to 40 g/10 min, preferably in the range of from 8 to 30 g/10 min, more preferably of from 10 to 30 g/10 min and most preferably in the range of from 14 to 28 g/10 min.

Melt flow rate is measured in accordance with ASTM D-1238 at a temperature of 365 °C and a load of 5 kg.

Poly(arylether sulfone)s are typically amorphous polymers, thus usually having a glass transition temperature. Preferably the poly(arylether sulfone)s have a glass transition temperature of at least 150 °C, preferably at least 160°C, even more preferably of at least 175 °C. In preferred embodiments the glass transition temperature is in the range of from 190 to 230 °C or in the range of from 230 to 280 °C.

The glass transition temperature can be measured by any suitable technique, Differential Scanning Calorimetry being a preferred method for determination of the glass transition temperature. Preferably the measurement is taken in accordance with the following heating/cooling cycle: 1$^{st}$ heating from room temperature to 350 °C at a rate of 10 °C/min, followed by cooling from 350 °C to room temperature at a rate of 20 °C/min, followed by a second heating from room temperature to 350 °C at a rate of 10°C/min. The measurement is made during the second heating. The determination is preferably made by a tangential construction procedure on the heat flow curve by constructing a first tangent line to the curve above the transition region and a second tangent line to the curve below the transition region. The temperature on the curve halfway between these tangent lines is the glass transition temperature.

The poly(arylether sulfone)s may, in addition to the units defined above, contain up to 50 mole%, preferably up to 25 mole % of other recurring units, preferably derived from the monomers given in table 1. In this case the $SO_2$ content mentioned above refers to the polymer as a whole.

If the poly(arylether sulfone) is a copolymer, it may have a structure of from 0 to 100 wt% random and from 0 to 100 wt% block wherein the % by weight refers to the weight based on the total weight of the copolymer. Preferably, when in copolymer form, the poly(arylether sulfone) has from 20 to 80 wt%, more preferably from 30 to 70 wt% and most preferably from 40 to 60 wt% random structure, the remainder being block structure. The random/block structure may be determined by $^1H$ and $^{13}C$ NMR spectroscopy techniques, in particular 2-D NMR spectroscopy including $^1H$-$^1H$ COSY, $^1H$-$^{13}C$ HSQC, $^1H$-$^{13}C$ HMBC and $^1$-D-$^1H$ and $^{13}C$-NMR techniques.

Preferred groups of additional recurring units besides those mentioned above are

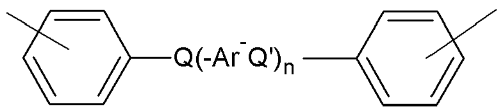

and

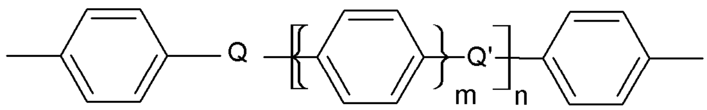

In which Q and Q' may be the same or different and preferably are CO or $SO_2$, n is in the range of from 0 to 3 (provided that n is not 0 where Q is $SO_2$) and m has a value of 1, 2 or 3.

Certain poly(arylether sulfone)s especially suitable as polymer matrix for the polymer compositions in accordance with the instant invention are described now as embodiments E1 to E4.

Embodiment E1

In embodiment E1 the poly(arylether sulfone)s are the so called poly(biphenylether sulfone)s, which for the purpose of this invention are intended to denote polycondensation polymers of which more than 50 % of the recurring

units are recurring units containing at least one optionally substituted p-biphenylene group

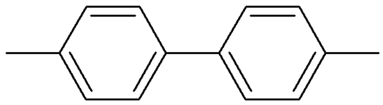

at least one ether group (-O-) and at least one sulfone group ($-SO_2-$).

The biphenylene unit may be unsubstituted, or it may be substituted by one or more substituents; the substituent(s) may be notably chosen from halogen atoms, $C_1$-$C_{12}$ alkyls, $C_1$-$C_{24}$ alkylaryls, $C_1$-$C_{24}$ aralkyls, $C_6$-$C_{18}$ aryls, and $C_1$-$C_{12}$ alkoxy groups; preferred substituents are halogen atoms, in particular fluorine atoms.

Preferably, the poly(biphenylether sulfone) has one or more recurring units having the following formula :

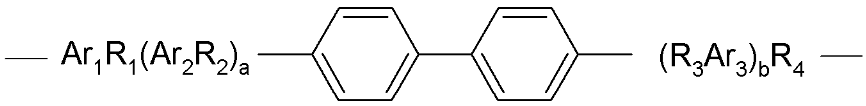

where $R_1$ through $R_4$ are any of -O-, $-SO_2-$, -S-, or -CO-, with the proviso that at least one of $R_1$ through $R_4$ is $-SO_2-$ and at least one of $R_1$ through $R_4$ is -O- ; $Ar_1$, $Ar_2$ and $Ar_3$ are arylene groups containing 6 to 24 carbon atoms, and are preferably phenylene or p-biphenylene; and a and b are either 0 or 1.

More preferably, the recurring units of the poly(biphenylether sulfone) are chosen from the following formulas 2 to 6 (in this order below)

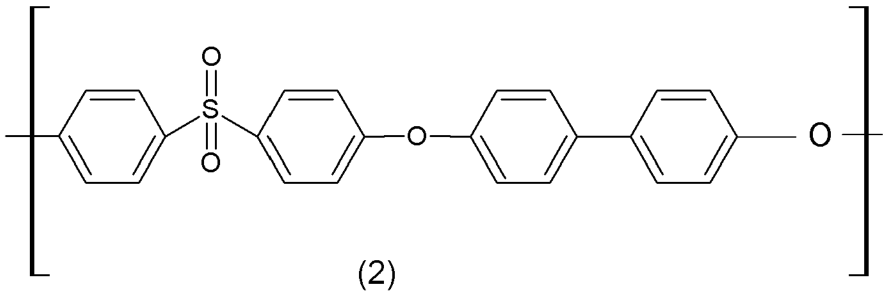

(2)

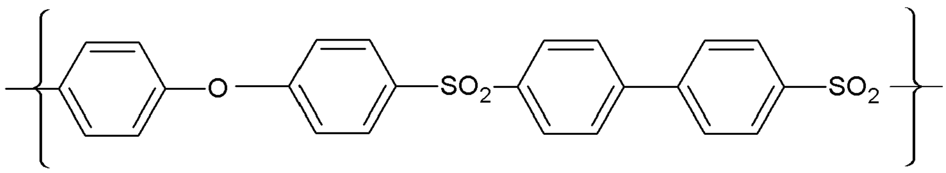

(3)

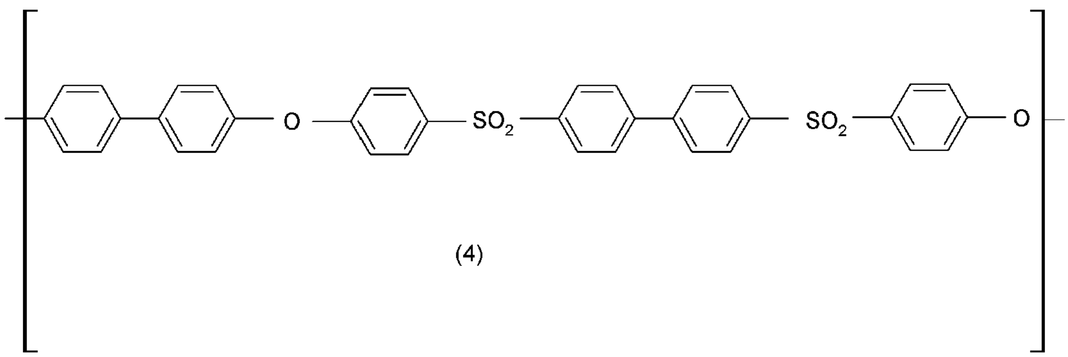

(4)

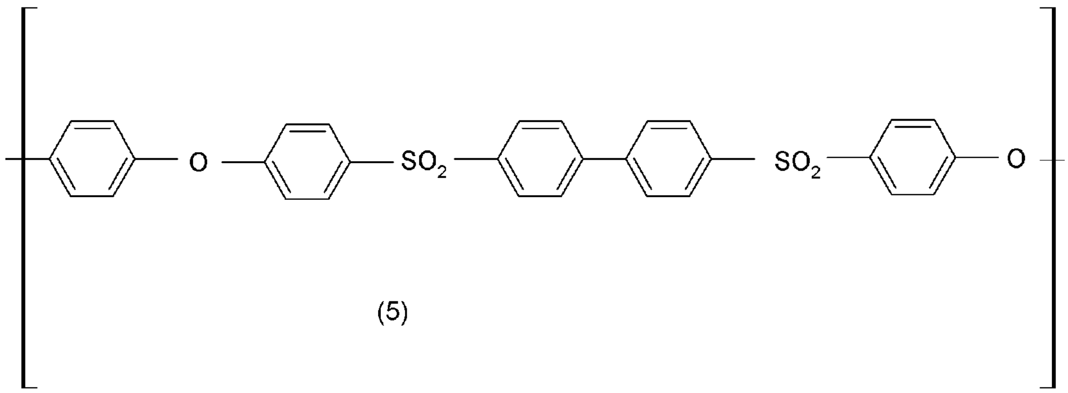

(5)

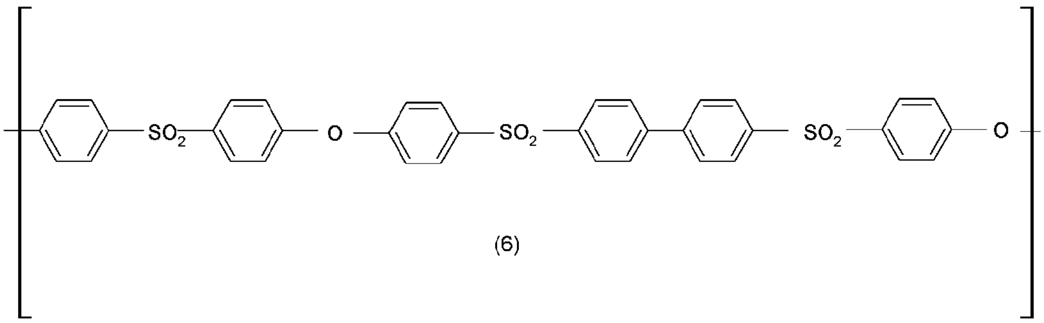

(6)

Still more preferably, the recurring units of the poly(biphenylether sulfone) are selected from the poly(biphenylether sulfone)s of formulas (2), (4) or (6) above or mixtures of these recurring units.

For the purpose of the instant invention, a polyphenylsulfone is intended to denote any polymer of which more than 50 % of the recurring units have the formula (2) above.

Another preferred poly(biphenylether sulfone) consists of recurring units of formulae (4) and (6) where the recurring unit (6) is present in an amount of from 10 to 99 % , preferably between 50 and 95 % , based on the total number of the recurring units of (4) and (6).

The poly(biphenylether sulfone) may be a poly(biphenylether diphenylsulfone) polycondensation polymer of which more than 50 % of the recurring units are recurring units of condensed molecules of a dihydroxybiphenyl group and a diphenyl sulfone group. A poly(biphenylether sulfone) that has recurring units of the first formula (2), i.e., condensed units of 4,4'-dihydroxybiphenyl and 4,4'-dichlorodiphenyl sulfone provides, in general, the best overall balance of cost and toughness.

The poly(biphenylether sulfone) may notably be a homopolymer or a copolymer such as a random or a block copolymer. When the poly (biphenylether sulfone) is a copolymer, its recurring units may notably be composed of recurring units of at least two different formulae chosen from formulae (2) to (6) above or may, in addition to such recurring units, comprise different recurring units, such as units (7), (8) and (9) below

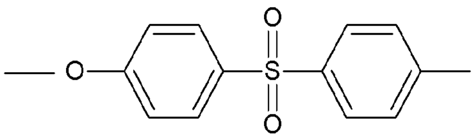

(7)

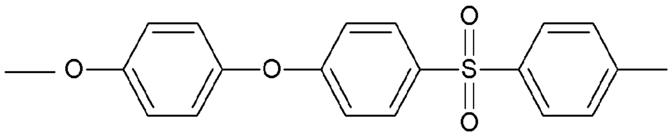

(8)

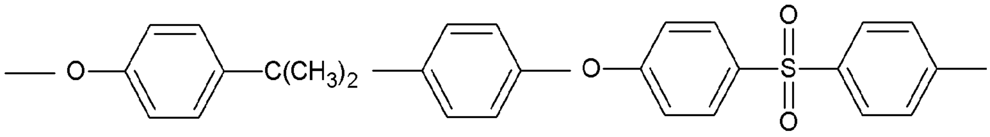

(9)

and mixtures thereof.

Preferably more than 80 % and more preferably more than 95 % of the recurring units are selected from formulae (2) to (6) above. Still more preferably the respective polymers essentially consist of or consist of such units. RADEL® R products from Solvay Advanced Polymers LLC are examples of respective polymers.

Excellent results are also obtained when the poly(biphenylether sulfone) is a copolymer of which essentially all or all of the recurring units are a mix of units of formulae (4) and (6) above, advantageously in a ratio of about 4:6. Respective products are available under the tradename EPISPIRE® poly(biphenylether sulfone) from Solvay Advanced Polymers LLC.

Embodiment E2

The polymers in accordance with this embodiment are commonly referred to as polysulfones, in particular a preferred representative as Bisphenol A polysulfone.

For the purpose of the instant invention, a polysulfone is intended to denote any polymer of which more than 50 % of the recurring units are recurring units of one or more formulae containing at least one ether group (-O-), at least one sulfone group ($-SO_2-$) and at least one group

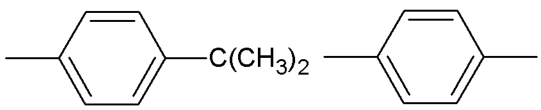

(10)

Preferably, the recurring units of the polysulfones in accordance with this embodiment are chosen from formulae (9) and (11)

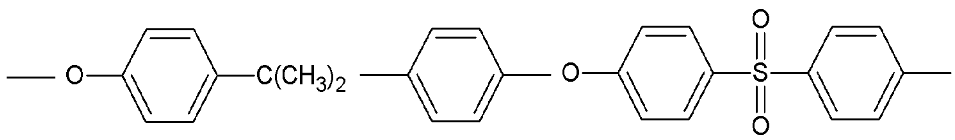

(9)

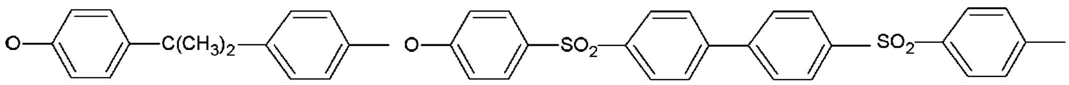

(11)

and mixtures thereof.

Very preferably the recurring units have the formula (10) above.

The polysulfone may be a homo or a copolymer such as a random or a block copolymer. Copolymers may be composed of mixtures of formulae (10) and (11) and optionally other recurring units of formulae (2) and (4) above or of formulae (7) and (8) above.

Preferably more than 80 % and more preferably more than 95 % of the recurring units of the polysulfone are recurring units of formulae (10) and (11), the most preferred polysulfone being a homopolymer of formula (10) which is commercially available from Solvay Advanced Polymers under the tradename UDEL®.

Embodiment E3

In this embodiment the poly(aryl ether sulfone) is a polyethersulfone.

For the purpose of the instant invention the term polyethersulfone is intended to denote any polymer of which more than 50 % of the recurring units are recurring units of formula (7).

The polyethersulfone may be a homo or a copolymer such as a random or a block copolymer. Copolymers

may advantageously contain a mixture of recurring units (7) and recurring units (2), (4), (8) and (9).

Preferably the polyethersulfone is a homopolymer or a copolymer of the recurring units (7) and/or recurring units of formula (8) or it can also be a mix of the previously cited homopolymer and copolymer.

Solvay Advanced Polymers commercializes various polyethersulfones under the tradename VERADEL®.

Embodiment E4

In embodiment 4 the poly(aryl ether sulfone) is a polyimidoethersulfone, which, for the purpose of the instant invention is intended to denote a polymer comprising at least 5 % of the recurring units of formula (12a) or its amic acid forms (12b) and (12c)

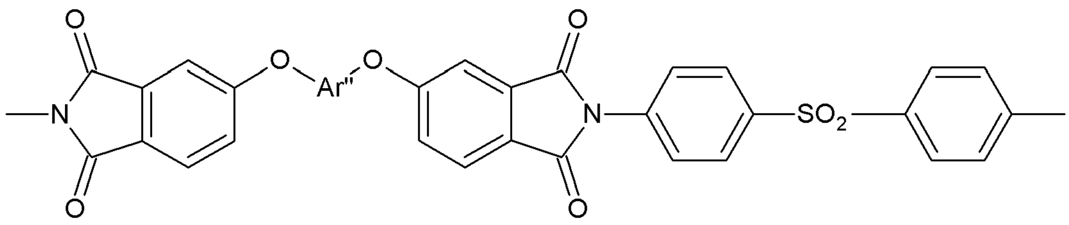

(12a)

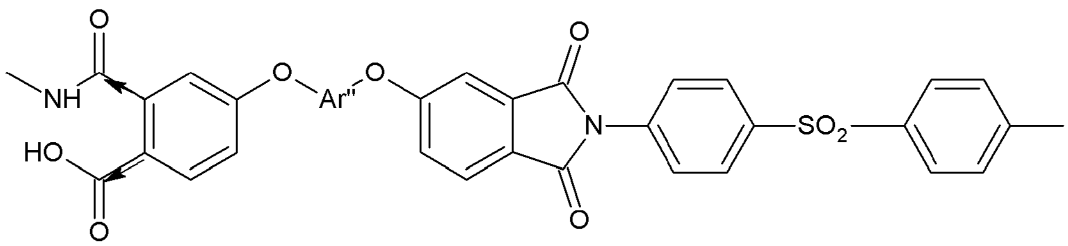

(12b)

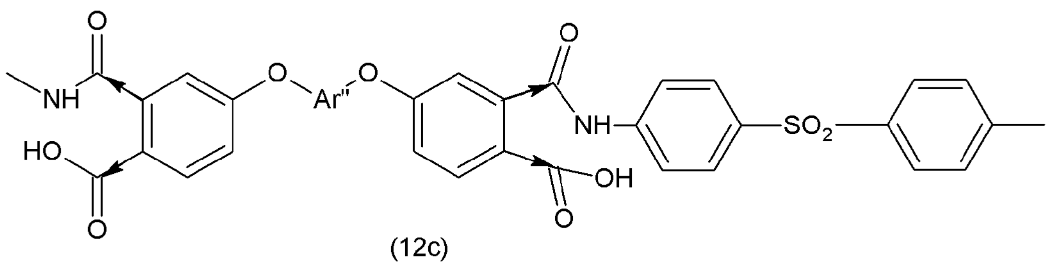

(12c)

The arrows in the graphical representation denote isomerism.

Ar" denotes a group of general formula

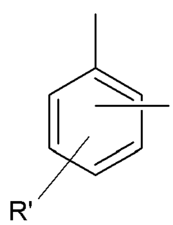

with the linking groups possibly being in ortho-, meta- or para-position and R' being a hydrogen atom or a $C_1$-$C_6$-alkyl radical

or of the following general formulae

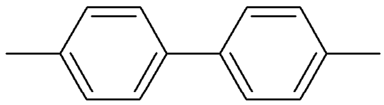

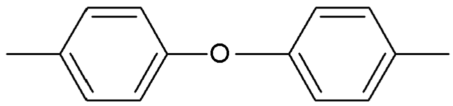

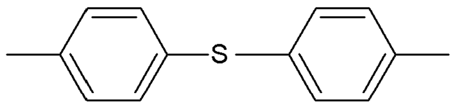

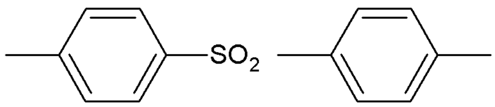

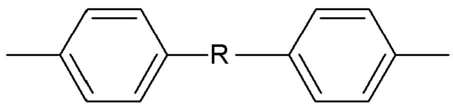

with R being an aliphatic divalent group of up to 6 carbon atoms, such as methylene, ethylene or isopropylene or the like and mixtures thereof.

Preferably more than 50 %, more preferably more than 80 % and still more preferably more than 95 % of the recurring units of the polyimidoethersulfone are recurring units of formulae (12a), (12b) and/or (12c). Most preferably essentially all or all of the recurring units are such units.

The polymer compositions in accordance with the invention can comprise one or more than one poly(aryl ether sulfones).

Another group of polyarylene polyethers which can be used in the compositions in accordance with the invention are the so called poly(aryl ether ketone)s (PAEK).

The term poly(aryl ether ketone) when used herein includes any polymer having more than 50 % of the recurring units derived from one or more formulae comprising at least one arylene group, at least one ether group (-O-) and at least one ketone group (-CO-).

Preferred recurring units of the PAEK are derived from formulae (13) to (17) below:

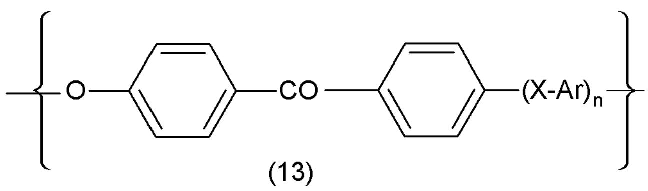

(13)

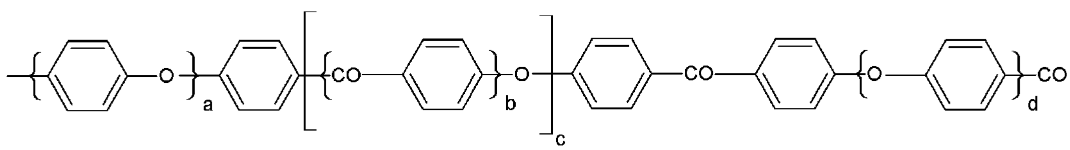

(14)

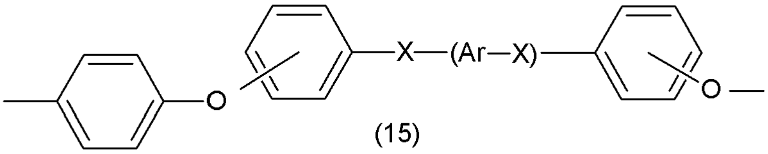

(15)

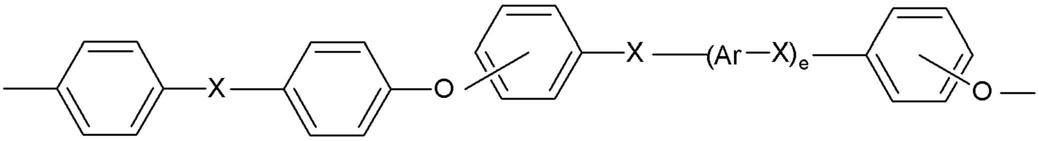

(16)

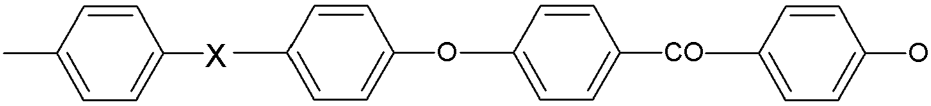

(17)

wherein

Ar is independently a divalent aromatic radical selected from phenylene, biphenylene or naphthylene,
X is independently -O-, -CO- or a direct bond,
n is an integer of from 0 to 3,
a is an integer of from 1 to 4,
b, c, d and e have independently the value 0 or 1
and d is preferably 0 if b is 1.

Preferred recurring units have the following formulae (18) to (37)

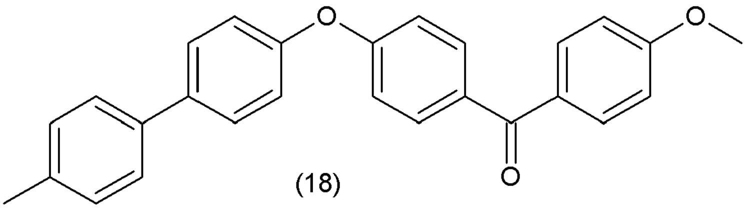

(18)

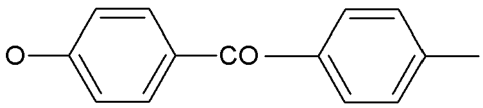

(19)

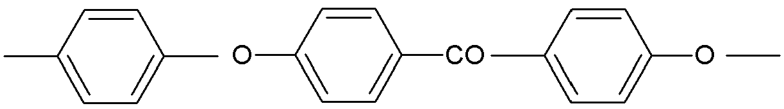

(20)

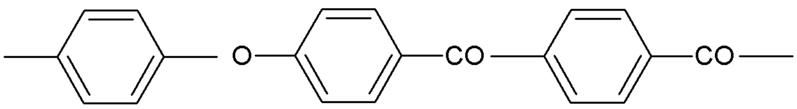

(21)

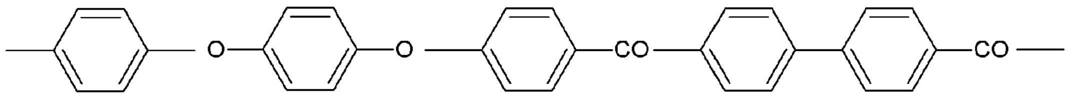

(22)

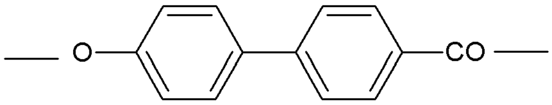

(23)

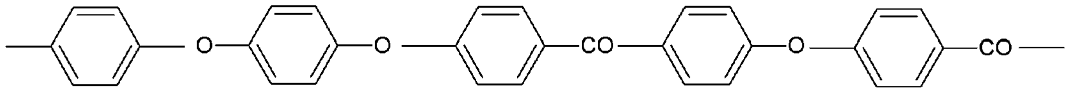

(24)

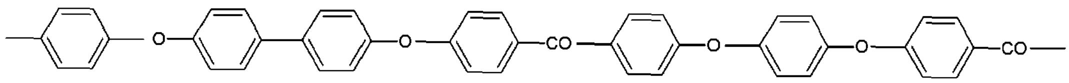

(25)

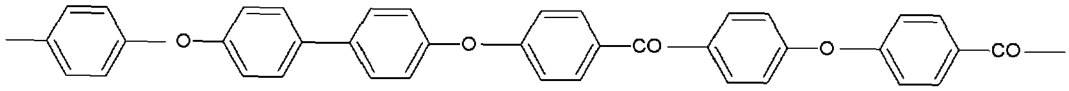

(26)

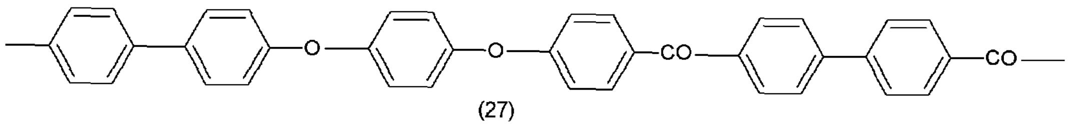

(27)

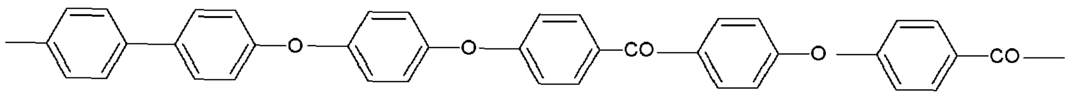

(28)

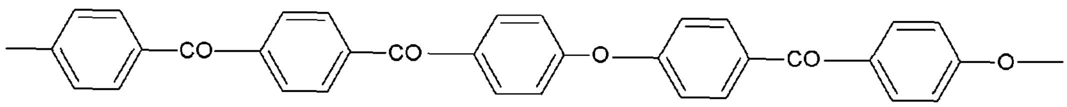

(29)

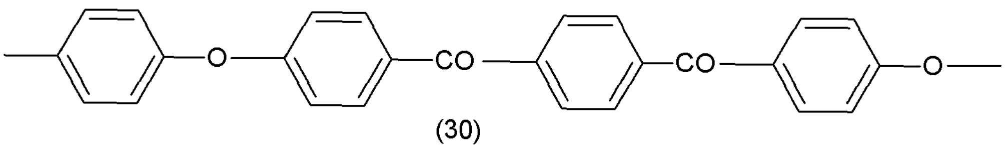

(30)

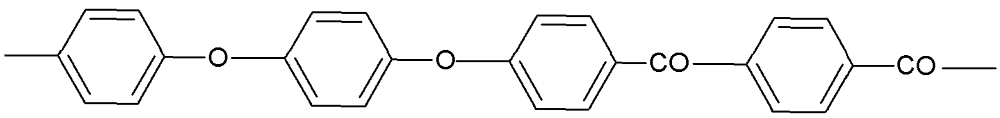

(31)

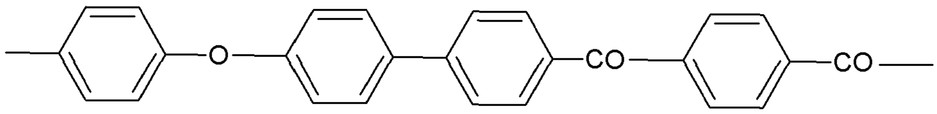

(32)

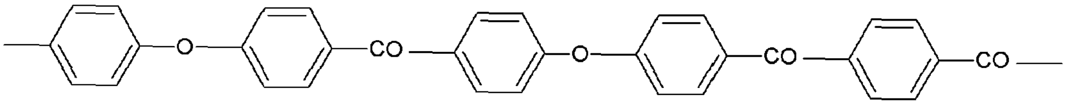

(33)

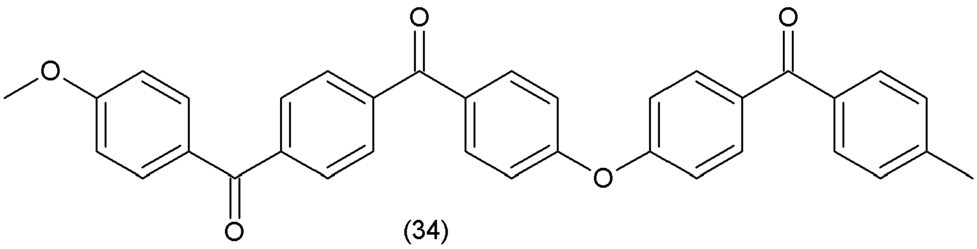

(34)

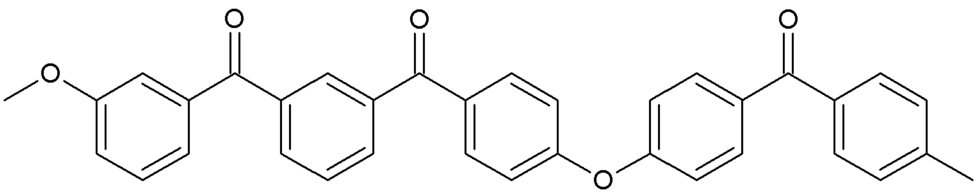

(35)

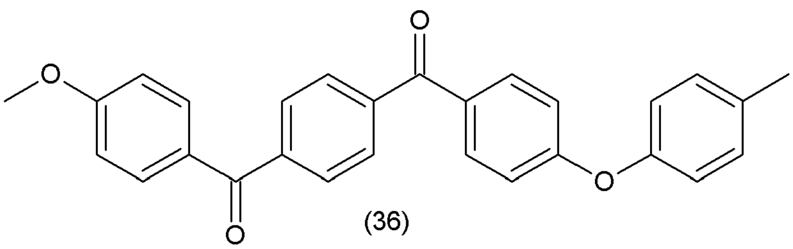

(36)

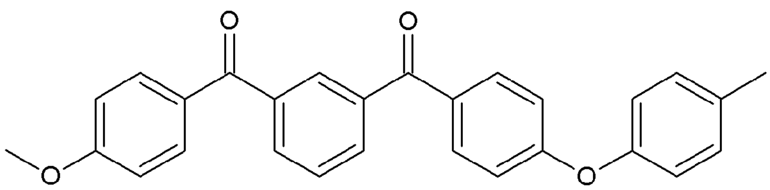

(37)

Preferred recurring units are those of formulae (18) to (20), particularly preferred those of formula (18).

Poly(arylether ketone)s are commonly named in accordance with a system indicating the sequence of ether groups (designated as E) and ketone groups (designated as K).

Thus a PEEK polymer comprises recurring units of formula (18) whereas PEK would be used for a polymer comprising recurring units of formula (19).

It is to be understood that a poly(arylether ketone) can be a homopolymer or a random, alternate or block copolymer comprising various combinations of recurring units of formulae (18) to (37). In addition the poly(arylether ketone)s can contain sulfone containing units as described hereinbefore.

PAEKs are generally prepared by aromatic nucleophilic substitution. According to a suitable embodiment an aromatic diol (e.g. hydroquinone, bisphenols or mixtures thereof) is deprotonated with e.g. sodium carbonate and the resulting phenoxide may then be reacted with a dihalobenzophenone via a nucleophilic substitution.

PAEKs are commercially available e.g. from Solvay Advanced Polymers LLC.

Another group of polymers suitable for use in the polymer compositions in accordance with the instant invention are the so called polyimides, as defined hereinbefore. Preferred representatives are the aromatic polyetherimides and polyamide-imides

Aromatic polyetherimides denote polymers of which more than 50 % of the recurring units comprise at least one aromatic ring, at least one imide group (as such or in its amic acid form) and at least one ether group.

Preferred polyetherimides comprise more than 80, preferably more than 95 % of such recurring units and most preferably essentially all or all of the recurring units are such recurring units.

Generally, the aforementioned recurring units can be represented by formulae (38a) to (38c), wherein (38b) and (38c) represent the amic acid forms of formula (38a)

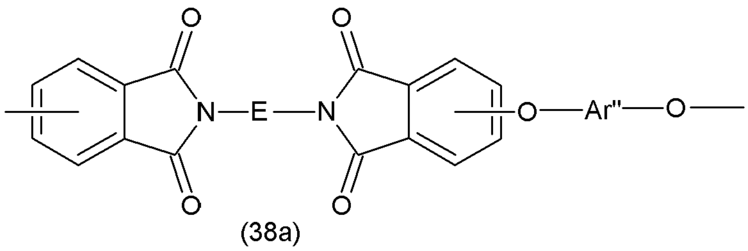

(38a)

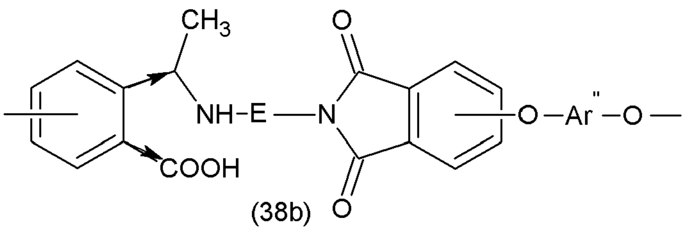

(38b)

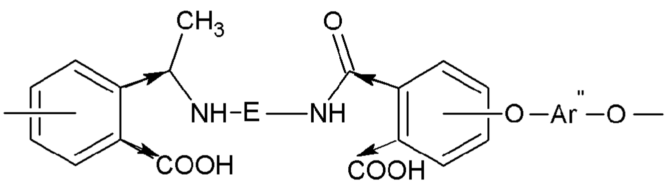

(38c)

wherein

E is chosen from the following formulae

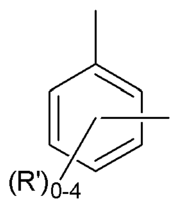

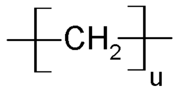

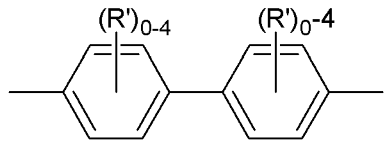

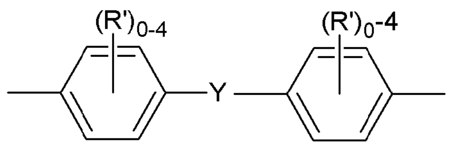

wherein R' denotes an alkyl radical with 1 to 6 carbon atoms, an aryl radical or halogen, u is an integer of from 1 to 6, Y is selected from
(Y-i) alkylenes with 1 to 6 carbon atoms, which may be substituted by halogen, preferably $-C(CH_3)_2-$, -(CH- or- $C(CF_3)_2-$,
(Y-ii) perfluoroalkylenes with 1 to 6 carbon atoms,
(Y-iii) cycloalkylenes with 4 to 8 carbon atoms,
(Y-iv) alkylidenes with 1 to 6 carbon atoms,
(Y-v) cycloalkylidenes with 4 to 8 carbon atoms,
(Y-vi) sulfonyl,
(Y-vii)-S-, $-CH_2-$, -O-, or -CO-, and

Ar" is selected from
aromatic hydrocarbon radicals having from 6 to 20 carbon atoms and halogenated or alkyl substituted derivatives thereof, wherein the alkyl group contains 1 to 6 carbon atoms,
alkylene and cycloalkylene radicals having from 2 to 20 carbon atoms, from terminated polydiorganosiloxanes
or from the following formulae

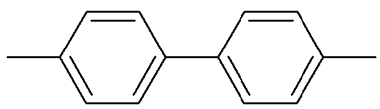

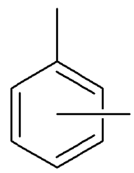

and

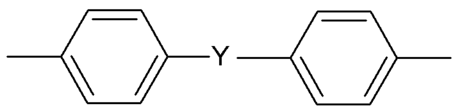

wherein Y is as defined above.

Methods for the manufacture of aromatic polyetherimides of the structures as defined above are known to the skilled man. Thus, e.g. any aromatic bis(ether anhydride)s of the formula

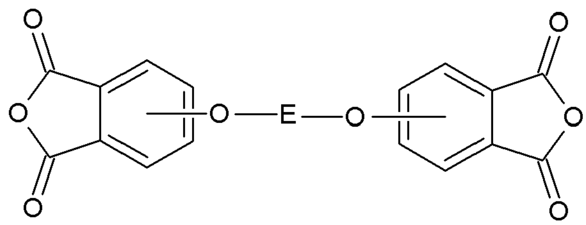

wherein E is as defined above can be reacted with a diamino compound of formula

$$H_2N\text{-}Ar''\text{-}NH_2$$

wherein Ar" is as defined above.

The reaction can be carried out in solution or in the melt and respective procedures are known to the skilled man.

Preferred bis(ether anhydrides) of the above formula are the following:

2,2'-bis[4-(2,3-dicarboxyphenoxy)phenyl]propane dianhydride,
4,4'-bis(-(2,3-dicarboxyphenoxy)diphenyl ether dianhydride,
1,3-bis-(2,3-dicarboxyphenoxy)benzene dianhydride,
4,4'-bis (2,3-dicarboxyphenoxy)diphenyl sulphide dianhydride
1,4-bis-(2,3-dicarboxyphenoxy)benzene dianhydride,
4,4'-bis(-(2,3-dicarboxyphenoxy)benzophenone dianhydride,
4,4'-bis(-(2,3-dicarboxyphenoxy)diphenyl sulfone dianhydride,
2,2'-bis[4-(3,4-dicarboxyphenoxy)phenyl]propane dianhydride,
4,4'-bis(-(3,4-dicarboxyphenoxy)diphenyl ether dianhydride,
4,4'-bis (3,4-dicarboxyphenoxy)diphenyl sulfide dianhydride,
1,3-bis-(3,4-dicarboxyphenoxy)benzene dianhydride,
1,4-bis-(3,4-dicarboxyphenoxy)benzene dianhydride,
4,4'-bis(-(3,4-dicarboxyphenoxy)benzophenone dianhydride,
4-((2,3-dicarboxyphenoxy)-4'-(3,4,-dicarboxyphenoxy)- diphenyl-2,2-propane dianhydride and mixtures of the foregoing.

Suitable organic diamines include e.g. m-phenylenediamine, p-phenylenediamine" 2,2-bis(p-aminophenyl)propane, 4.4'-diaminodiphenyl-methane, 4.4'-diaminodiphenyl sulfide,
4,4'-diaminodiphenyl sulfone, 4,4'-diaminodiphenyl ether, 1,5-diaminonaphthalene, 3,3-dimethylbenzidine and 3,3'-dimethoxybenzidine and mixtures of these compounds.

In the recurring units of the aromatic polyetherimide E is preferably chosen from

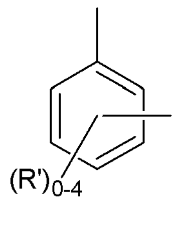

and more preferably E is m-phenylene.

Ar" is preferably chosen from

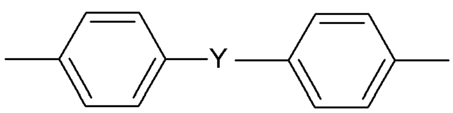

with Y being defined as above.

A preferred example for Ar" is

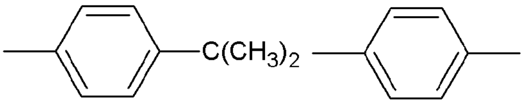

Polymers commercially available under the tradename Ultem® and having recurring units

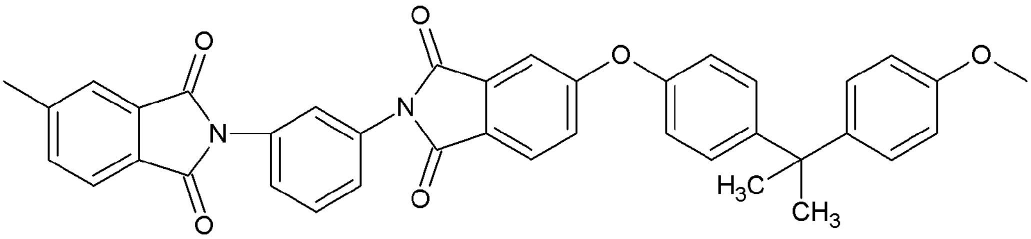

which may also be present in their respective amic acid form are a particularly preferred group of aromatic polyetherimides.

Aromatic polyamide-imides can also be used as polymers in the polymer compositions in accordance with the instant invention. Such polymers comprise more than 50 % of recurring units comprising at least one aromatic ring, at least one imide group (as such or in its amic acid form) and at least one amide group which is not included in the amic acid form of an imide group.

Preferred recurring units are units of formula (39) which can be present as such or in their amic acid form

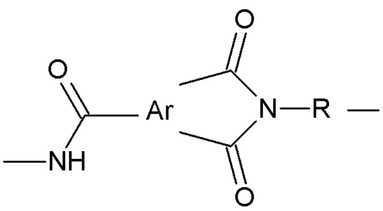

(39)

where Ar is selected from

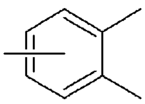 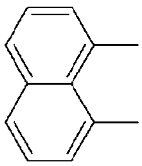 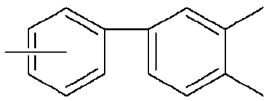 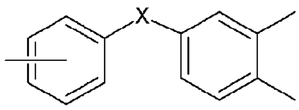

with X being -CO-, $(CH_2)_n$-, -$C(CF_3)_n$-, or-$(CF_2)_n$-, or from

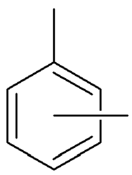

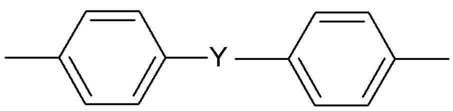

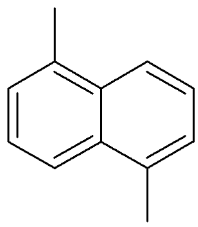

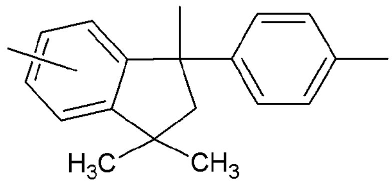

with Y being -S-, $-SO_2-$, $-(CH_2)_n-$, -CO-, $-C(CF_3)_n-$ and $-(CF_2)_n-$, where n is an integer of from 0 to 5.

Preferred polyamide-imides are those having recurring units of formulae (40) to (42)

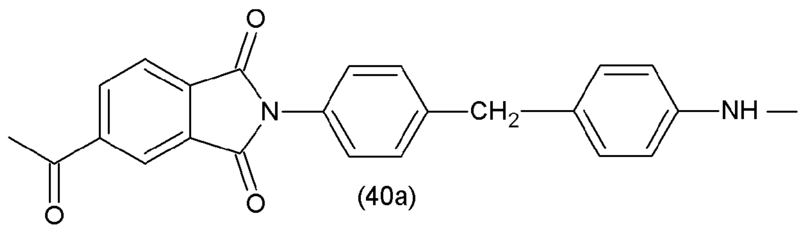

(40a)

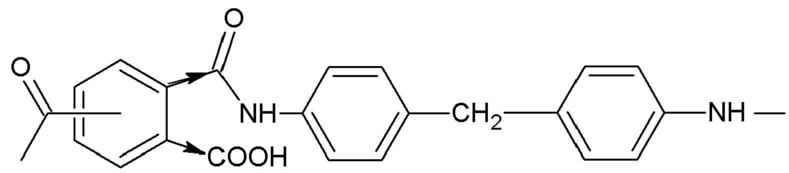

(40b)

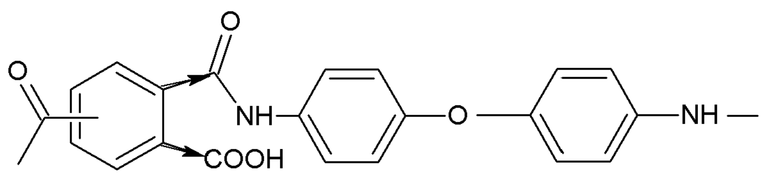

(41b)

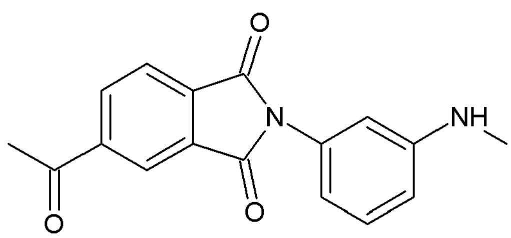

(42a)

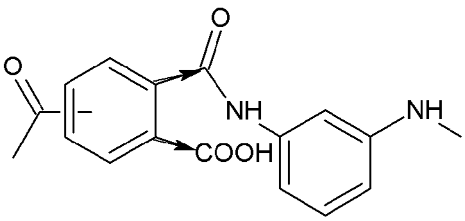

(42b)

The attachment of the two amide groups to the aromatic ring system as shown in the polyamide-amic acid configurations (41 b) and (42b) is to be understood to represent the 1,3- and 1,4- polyamide-amic acid configurations.

Preferred are polyamide-imides comprising a combination of recurring units (41) and (42); respective products where essentially all or all recurring units are derived from formulae (41) and (42) are commercially available from Solvay Advanced Polymers LLC under the tradename TORLON®.

Preferred polyamide-imides are obtainable from the reaction of derivatives of tricarboxylic acid IIIa and aromatic diprimary amines IIIb and IIIc

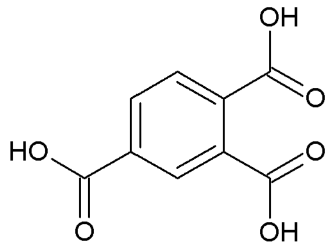

(IIIa)

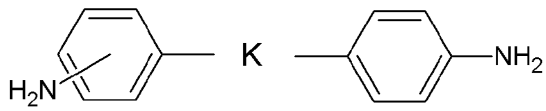

(IIIb)

wherein K is selected from the group consisting of -O-, -S-, -CO-, $-SO_2-$, $-C(CH_3)_2-$ and wherein the amino group in the indicated left ring is in m- or p-position to the bridging substituent K,

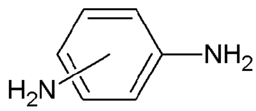

(IIIc)

wherein the amino groups are in m- or p-position to each other.

Particularly preferred polyamide-imides are obtained via polycondensation of trimellitic acid anhydride (the anhydride of IIIa) and 4,4'-diaminodiphenylmethane, 4,4'-diaminodiphenylether or m-phenylenediamine or mixtures thereof.

A further group of suitable polymers for use in the polymer compositions of the instant invention are halogenated polymers.

The term "halogenated polymers" is understood to denote both homopolymers of halogenated monomers and the copolymers which the halogenated monomers form with one another or with non-halogenated monomers. These copolymers can in particular be random copolymers, block copolymers or grafted copolymers.

Likewise and for the avoidance of doubt, the terms "polymers of <monomer type> monomers" are intended to denote both homopolymers of monomers of the specified type and the copolymers which the monomers of the specified type form with one another or with monomers of one or more other types. These copolymers can in particular be random copolymers, block copolymers or grafted copolymers. For example, the terms "polymers of chlorinated vinyl monomers" are intended to denote both homopolymers of chlorinated vinyl monomers and the copolymers which the chlorinated vinyl monomers form with one another or with one or more monomers other than chlorinated vinyl monomers.

The term "halogenated monomer" is understood to denote any ethylenically unsaturated monomer which comprises at least one halogen atom. Mention may be made, as examples of halogenated monomers, of halogenated vinyl monomers, preferably halogenated styrene monomers, such as 4-bromostyrene, halogenated (meth)acrylic monomers,

such as trifluoroethyl acrylate, and halogenated conjugated dienes, such as chloroprene.

Advantageously at least 50 mol% and preferably at least 90 mol% of the recurring units of the halogenated polymers are derived from one or more ethylenically unsaturated monomers chosen from halogenated monomers. In certain cases, essentially all, or even all the recurring units of the halogenated polymers are derived from one or more halogenated monomer(s).

The halogenated monomers are preferably selected from the group consisting of halogenated vinyl monomers, halogenated vinyl ether monomers and mixtures thereof.

The term "halogenated vinyl monomers" is understood to denote monoethylenically unsaturated halogenated monomers which are aliphatic and which comprise, as sole heteroatom(s), one or more halogen atoms. Mention may be made, as examples of halogenated vinyl monomers, of brominated vinyl monomers, such as vinyl bromide, fluorinated vinyl monomers and chlorinated vinyl monomers.

The halogenated monomers are particularly preferably chosen from chlorinated vinyl monomers, fluorinated vinyl monomers and mixtures thereof.

The term "chlorinated vinyl monomers" is understood to denote monoethylenically unsaturated chlorinated monomers which are aliphatic and which comprise, as sole heteroatom(s), one or more chlorine atoms. Mention may be made, as examples of chlorinated vinyl monomers, of chlorinated vinyl monomers for which the number of chlorine atoms is 1, chlorinated vinyl monomers for which the number of chlorine atoms is 2, trichloroethylene, 1,1,3-trichloropropene and perchlorinated monomers such as tetrachloroethylene.

A first preferred family of chlorinated vinyl monomers is composed of chlorinated vinyl monomers for which the number of chlorine atoms is 1. Mention may be made, as examples of chlorinated vinyl monomers for which the number of chlorine atoms is 1, of allyl chloride, crotyl chloride and, with a very particular mention, vinyl chloride.

A second preferred family of chlorinated vinyl monomers is composed of chlorinated vinyl monomers for which the number of chlorine atoms is 2. Mention may be made, as examples of chlorinated vinyl monomers for which the number of chlorine atoms is 2, of 1,1-dichloropropene, 1,3-dichloropropene, 2,3-dichloropropene and, with a very particular mention, vinylidene chloride.

The term "fluorinated vinyl monomers" is understood to denote monoethylenically unsaturated fluorinated monomers which are aliphatic and which comprise, as sole heteroatom(s), one or more fluorine atoms and optionally, in addition, one or more halogen atoms other than fluorine atoms. Mention may be made, as examples of fluorinated vinyl monomers, trifluoroethylene, perfluorinated vinyl monomers such as tetrafluoroethylene and hexafluoropropylene, fluorinated vinyl monomers devoid of halogen atoms other than fluorine atoms and for which the number of fluorine atoms is 1, and fluorinated vinyl monomers devoid of halogen atoms other than fluorine atoms and for which the number of fluorine atoms is 2.

A first preferred family of fluorinated vinyl monomers is composed of fluorinated vinyl monomers devoid of halogen atoms other than fluorine atoms and for which the number of fluorine atoms is 1. Mention may be made, as examples of such monomers, of allyl fluoride and, with a very particular mention, vinyl fluoride.

A second preferred family of fluorinated vinyl monomers is composed of fluorinated vinyl monomers devoid of halogen atoms other than fluorine atoms and for which the number of fluorine atoms is 2 or 3. Mention may be made, as examples of such monomers, of 3,3,3-trifluoropropene and, with a very particular mention, vinylidene fluoride.

The term "halogenated vinyl ether monomers" is understood to denote monoethylenically unsaturated halogenated monomers which are aliphatic and which comprise, as sole heteroatom(s), one or more halogen atoms on the one hand and one or more oxygen atoms providing ether functionalities on the other hand (i.e. one or more halogen atoms and one or more oxygen atoms providing ether functionalities must be present in the halogenated vinyl ether monomers). Mention may be made, as examples of halogenated vinyl ether monomers, of chlorinated vinyl ether monomers, such as perchloromethylvinylether, and fluorinated vinyl ether monomers.

The term "fluorinated respectively chlorinated vinyl ether monomers" is understood to denote monoethylenically unsaturated fluorinated respectively chlorinated monomers which are aliphatic and which comprise, as sole heteroatom(s) (i.e. atoms other than carbon atoms), (i) one or more oxygen atoms providing ether functionalities on one hand, and (ii) one or more fluorine respectively chlorine atoms and, optionally in addition, one or more halogen atoms other than fluorine respectively chlorine atoms on the other hand (i.e. one or more fluorine respectively chlorine atoms and one or more oxygen atoms providing ether functionalities must be present in the fluorinated respectively chlorinated vinyl ether monomers). Mention may be made, as examples of fluorinated vinyl ether monomers, of perfluorovinylethers, such as perfluoromethylvinylether, perfluoroethylvinylether, perfluoropropylvinylether and $C_4$-$C_6$ perfluoroalkylvinylethers. Fluorinated vinyl ether monomers are general preferred over chlorinated vinyl ether monomers.

According to a first preferred alternative (i), the halogenated polymers are obtained by polymerizing a single halogenated monomer.

According to a second preferred alternative (ii), the halogenated polymers are obtained by polymerizing several ethylenically unsaturated monomers, at least one of which is chosen from halogenated monomers.

According to the alternative form (ii), the halogenated polymers can optionally, in addition, comprise units

derived from one or more non-halogenated monomers.

Generally, if applicable, the non-halogenated monomers are preferably chosen from styrene monomers, such as styrene, (meth)acrylic monomers, such as n-butyl acrylate and methyl methacrylate, vinyl esters, such as vinyl acetate, and olefinic monomers, such as propylene and butadiene.

The halogenated polymers useful in accordance with the instant invention can just as easily be homopolymers of halogenated monomers as copolymers formed by halogenated monomers with one another or with non-halogenated monomers.

In addition, they are preferably polymers of halogenated vinyl monomers. Particularly preferably, they are chosen from polymers of chlorinated vinyl monomers and polymers of fluorinated vinyl monomers.

Mention may be made, as examples of polymers of chlorinated vinyl monomers, of polymers of chlorinated vinyl monomers for which the number of chlorine atoms is 1, polymers of chlorinated vinyl monomers for which the number of chlorine atoms is 2, trichloroethylene polymers, 1,1,3-trichloropropene polymers and tetrachloroethylene polymers.

A first preferred family of polymers of chlorinated vinyl monomers is composed of polymers of chlorinated vinyl monomers for which the number of chlorine atoms is 1. Mention may be made, as examples of such polymers, of allyl chloride polymers, crotyl chloride polymers and, with a very particular mention, vinyl chloride polymers.

A second preferred family of polymers of chlorinated vinyl monomers is composed of polymers of chlorinated vinyl monomers for which the number of chlorine atoms is 2. Mention may be made, as examples of such polymers, of 1,1-dichloropropene polymers, 1,3-dichloropropene polymers, 2,3-dichloropropene polymers and, with a very particular mention, vinylidene chloride polymers.

Mention may be made, as examples of polymers of fluorinated vinyl monomers, of trifluoroethylene polymers, polymers of perfluorinated vinyl monomers, such as tetrafluoroethylene polymers and hexafluoropropylene polymers, polymers of fluorinated vinyl monomers devoid of halogen atoms other than fluorine atoms and for which the number of fluorine atoms is 1, polymers of fluorinated vinyl monomers devoid of halogen atoms other than fluorine atoms and for which the number of fluorine atoms is 2, and thermoprocessible per(halo)fluoropolymers (as described in more detail hereinafter).

A first preferred family of polymers of fluorinated vinyl monomers is composed of polymers of fluorinated vinyl monomers devoid of halogen atoms other than fluorine atoms and for which the number of fluorine atoms is 1. Mention may be made, as examples of such polymers, of allyl fluoride polymers and, with a very particular mention, vinyl fluoride polymers.

A second preferred family of polymers of fluorinated vinyl monomers is composed of polymers of fluorinated vinyl monomers devoid of halogen atoms other than fluorine atoms and for which the number of fluorine atoms is 2 or 3. Mention may be made, as examples of such polymers, of 3,3,3-trifluoropropene polymers and, with a very particular mention, vinylidene fluoride polymers.

In certain embodiments of the present invention, at least 50 mol%, at least 80 mol%, or at least 90 mol% of the recurring units of any above cited subspecies of halogenated polymers (e.g. polymers of chlorinated vinyl monomers) are derived from the one or more corresponding species of halogenated monomers (e.g. from one or more chlorinated vinyl monomers, when polymers of halogenated vinyl monomers are considered). In still other embodiments of the present invention, essentially all, or even all the recurring units of any above cited subspecies of halogenated polymers are derived from the one or more corresponding species of halogenated monomers.

Another preferred group of halogenated polymers are per(halo)fluoropolymers.
For the purpose of this invention, the term "per(halo)fluoropolymer" is intended to denote a fluoropolymer substantially free of hydrogen atoms.

The per(halo)fluoropolymer can comprise one or more halogen atoms (Cl, Br, I), different from fluorine.

The term "substantially free of hydrogen atom" is understood to mean that the per(halo)fluoropolymer consists essentially of recurring units derived from ethylenically unsaturated monomers comprising at least one fluorine atom and free of hydrogen atoms [per(halo)fluoromonomer (PFM)].

The per(halo)fluoropolymer can be a homopolymer of a per(halo)fluoromonomer (PFM) or a copolymer comprising recurring units derived from more than one per(halo)fluoromonomer (PFM).

Per(halo)fluoropolymers (PFM) can be selected from the group consisting of fluorinated ether monomers, fluorinated vinyl ether monomers and mixtures thereof. They can also be per(halo)fluoropolymers other than halogenated vinyl monomers; for example, they can comprise recurring units derived from one or more non aliphatic per(halo)fluoromonomers.

Non limitative examples of suitable per(halo)fluoromonomers (PFM) are notably :

- $C_2$-$C_8$ perfluoroolefins, such as tetrafluoroethylene (TFE) and hexafluoropropylene (HFP);
- chloro- and/or bromo- and/or iodo- $C_2$-$C_6$ per(halo)fluoroolefins, like chlorotrifluoroethylene, bromotrifluoroethylene;
- per(halo)fluoroalkylvinylethers complying with general formula $CF_2$=$CFOR_{f1}$ in which $R_{f1}$ is a $C_1$-$C_6$ per(halo)fluor-

oalkyl, such as $-CF_3$, $-C_2F_5$, $-C_3F_7$ ;

- per(halo)fluoro-oxyalkylvinylethers complying with general formula $CF_2=CFOX_{01}$, in which $X_{01}$ is a $C_1$-$C_{12}$ per(halo)fluorooxyalkyl having one or more ether groups, like perfluoro-2-propoxy-propyl group;
- per(halo)fluoro-methoxy-alkylvinylethers complying with general formula $CF_2=CFOCF_2OR_{f2}$ in which $R_{f2}$ is a $C_1$-$C_6$ per(halo)fluoroalkyl, such as $-CF_3$, $-C_2F_5$, $-C_3F_7$ or a $C_1$-$C_6$ per(halo)fluorooxyalkyl having one or more ether groups, such as $-C_2F_5$-O-$CF_3$;
- perfluorodioxoles of formula :

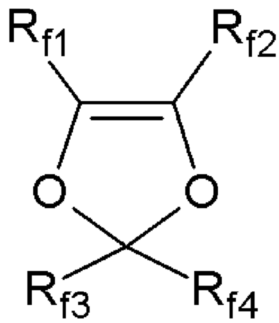

wherein each of $R_{f1}$, $R_2$, $R_{f3}$, $R_{f4}$, independently from one another, is a fluorine atom, a $C_1$-$C_6$ perfluoroalkyl group, optionally comprising one or more oxygen atom, e.g. $-CF_3$, $-C_2F_5$, $-C_3F_7$, $-OCF_3$, $-OCF_2CF_2OCF_3$; preferably a perfluorodioxole complying with formula here above, wherein $R_{f1}$ and $R_{f2}$ are fluorine atoms and $R_{f3}$ and $R_{f4}$ are perfluoromethyl groups ($-CF_3$) [perfluoro-2,2-dimethyl-1,3-dioxole (PDD)], or a per(halo)fluorodioxole complying with formula here above, wherein $R_{f1}$, $R_{f3}$ and $R_{f4}$ are fluorine atoms and $R_{f2}$ is a perfluoromethoxy group ($-OCF_3$) [2,2,4-trifluoro-5-trifluoromethoxy-1,3-dioxole or perfluoromethoxydioxole (MDO)].

The per(halo)fluoropolymer is advantageously chosen among copolymers of tetrafluoroethylene (TFE) with at least one per(halo)fluoromonomer (PFM) different from TFE. The TFE copolymers as above detailed comprise advantageously at least 1.5 % wt, preferably at least 5 % wt, more preferably at least 7 % wt of recurring units derived from the per(halo)fluoromonomer (PFM).

The TFE copolymers as above detailed comprise advantageously at most 30 % wt, preferably at most 25 % wt, more preferably 20 % wt of recurring units derived from the per(halo)fluoromonomer (PFM).

Good results have been obtained with TFE copolymers as above detailed comprising at least 2 % wt and at most 30 % wt of recurring units derived from the per(halo)fluoromonomer (PFM).

Preferred per(halo)fluoropolymers [polymers (A)] are selected among TFE copolymers comprising recurring units derived from at least one per(halo)fluoromonomer (PFM) chosen among the group consisting of :

1. perfluoroalkylvinylethers complying with formula $CF_2=CFOR_{f1'}$, in which $R_{f1'}$ is a $C_1$-$C_6$ perfluoroalkyl, e.g. $-CF_3$, $-C_2F_5$, $-C_3F_7$; and/or
2. perfluoro-oxyalkylvinylethers complying with general formula $CF_2=CFOX_0$, in which $X_0$ is a $C_1$-$C_{12}$ perfluorooxyalkyl having one or more ether groups, like perfluoro-2-propoxy-propyl group; and/or
3. $C_3$-$C_8$ perfluoroolefins, such as hexafluoropropene (HFP); and/or
4. perfluorodioxoles of formula :

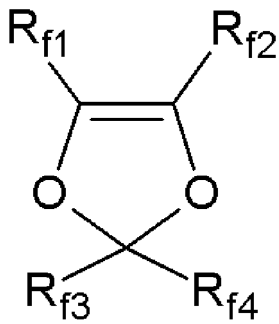

wherein each of $R_{f1}$, $R_{f2}$, $R_{f3}$, $R_{f4}$, equal or different of each other, is independently a fluorine atom, a $C_1$-$C_6$ per-

fluoroalkyl group, optionally comprising one or more oxygen atom, e.g. $-CF_3$, $-C_2F_5$, $-C_3F_7$, $-OCF_3$, $-OCF_2CF_2OCF_3$.

More preferred per(halo)fluoropolymers are selected among TFE copolymers comprising recurring units derived from at least one per(halo)fluoromonomer (PFM) chosen among the group consisting of :

1. perfluoroalkylvinylethers complying with general formula $CF_2=CFOR_{f1}$ in which $R_{f1}$ is a $C_1$-$C_6$ perfluoroalkyl;
2. perfluoro-oxyalkylvinylethers complying with general formula $CF_2=CFOX_{01}$, in which $X_{01}$ is a $C_1$-$C_{12}$ perfluorooxyalkyl having one or more ether groups;
3. $C_3$-$C_8$ perfluoroolefins; and
4. mixtures thereof.

According to a first alternative, the per(halo)fluoropolymer is chosen among TFE copolymers comprising recurring units derived from HFP and optionally from at least one per(halo)fluoroalkylvinylether, as above defined, preferably from at least one perfluoroalkylvinylether complying with general formula $CF_2=CFOR_{f1'}$ in which $R_{f1'}$ is a $C_1$-$C_6$ perfluoroalkyl.

Preferred per(halo)fluoropolymers according to this embodiment are selected among TFE copolymers comprising (preferably consisting essentially of) recurring units derived from tetrafluoroethylene (TFE) and hexafluoropropylene (HFP) in an amount ranging from 3 to 15 wt % and, optionally, from 0.5 to 3 wt % of at least one perfluoroalkylvinylether, as above defined.

The expression 'consisting essentially of' is used within the context of the present invention for defining constituents of a polymer to take into account end chains, defects, irregularities and monomer rearrangements which might be comprised in said polymers in minor amounts, without this modifying essential properties of the polymer.

A description of suitable per(halo)fluoropolymers can be found notably in US 4029868, US 5677404 US 5703185 and in US 5688885.

Suitable per(halo)fluoropolymers are commercially available under the trademark TEFLON® FEP 9494, 6100 and 5100 from E.I. DuPont de Nemours, or from Daikin (e.g. FEP NP-101 material), or from Dyneon LLC (FEP 6322).

Good results within this group have been obtained with TFE copolymers comprising (preferably, consisting essentially of) recurring units derived from tetrafluoroethylene (TFE) and hexafluoropropylene (HFP) in an amount ranging from 4 to 12 wt % and either perfluoro(methyl vinyl ether), perfluoro(ethyl vinyl ether) or perfluoro(propyl vinyl ether) in an amount from 0.5 to 3 % wt.

Alternatively, the per(halo)fluoropolymer is chosen among TFE copolymers comprising recurring units derived from at least one per(halo)fluoroalkylvinylether, as above defined, preferably from at least one perfluoroalkylvinylether, as above defined and optionally further comprising recurring units derived from $C_3$-$C_8$ perfluoroolefins.

Good results within this second embodiment have been obtained with TFE copolymers comprising recurring units derived from one or more than one perfluoroalkylvinylether as above specified; particularly good results have been achieved with TFE copolymers wherein the perfluoroalkylvinylether is perfluoromethylvinylether (of formula $CF_2=CFOCF_3$), perfluoroethylvinylether (of formula $CF_2=CFOC_2F_5$), perfluoropropylvinylether (of formula $CF_2=CFOC_3F_7$) and mixtures thereof.

According to a preferred variant of the second embodiment of the invention, the per(halo)fluoropolymer is advantageously a TFE copolymer consisting essentially of:

(a) from 3 to 13 %, preferably from 5 to 12 % by weight of recurring units derived from perfluoromethylvinylether;
(b) from 0 to 6 % by weight of recurring units derived from one or more than one fluorinated comonomer different from perfluoromethylvinylether and selected from the group consisting of perfluoroalkylvinylethers complying with general formula $CF_2=CFOR_{f1'}$ in which $R_{f1'}$ is a $C_1$-$C_6$ perfluoroalkyl and perfluoro-oxyalkylvinylethers complying with general formula $CF_2=CFOX_{01'}$, in which $X_{01'}$ is a $C_1$-$C_{12}$ perfluorooxyalkyl having one or more ether groups; preferably derived from perfluoroethylvinylether and/or perfluoropropylvinylether ;
(c) recurring units derived from tetrafluoroethylene, in such an amount that the sum of the percentages of the recurring units (a), (b) and (c) is equal to 100 % by weight.

Copolymers of TFE and perfluoromethylvinylether (MFA) and perfluoroalkoxy polymers (PFA) suitable to be used for the composition of the invention are commercially available from Solvay Solexis under the trade name of HYFLON® PFA P and M series and HYFLON® MFA.

According to another preferred variant, the per(halo)fluoropolymer is advantageously a TFE copolymer consisting essentially of :

(a) from 0.5 to 5 % by weight of recurring units derived from perfluoromethylvinylether;
(b) from 0.4 to 4.5 % by weight of recurring units derived from one or more than one fluorinated comonomer different

from perfluoromethylvinylether and selected from the group consisting of perfluoroalkylvinylethers, as above detailed and/or perfluoro-oxyalkylvinylethers, as above detailed; preferably derived from perfluoroethylvinylether and/or perfluoropropylvinylether ;

(c) from 0.5 to 6 % weight of recurring units derived from at least one $C_3$-$C_8$ perfluoroolefins, preferably derived from hexafluoropropylene; and

(d) recurring units derived from tetrafluoroethylene, in such an amount that the sum of the percentages of the recurring units (a), (b), (c) and (d) is equal to 100 % by weight.

For the purpose of the present invention, by the term "thermoprocessible" is meant that the per(halo)fluoropolymer can be processed (i.e. fabricated into shaped articles such as films, fibers, tubes, fittings, wire coatings and the like) by conventional melt extruding, injecting or casting means by the action of the temperature. This generally requires that the melt viscosity at the processing temperature be no more than $10^8$ Pa x sec, preferably from 10 to $10^8$ Pa x sec.

Thus, preferred per(halo)fluoropolymers are distinguishable from "non thermoprocessible" fluoropolymers, like notably PTFE, which cannot be processed by conventional melt extruding, injecting or casting means, and which generally exhibit a melt viscosity at the processing temperature exceeding $10^8$ Pa x sec.

The melt viscosity of the per(halo)fluoropolymer can be measured according to ASTM D-1238, using a cylinder, orifice and piston tip made of a corrosion-resistant alloy, charging a sample to the 9.5 mm inside diameter cylinder which is maintained at a temperature exceeding melting point, extruding the sample through a 2.10 mm diameter, 8.00 mm long square-edged orifice under a load (piston plus weight) of 5 kg. Melt viscosity is calculated in Pa x sec from the observable extrusion rate in grams per minute.

Also, the per(halo)fluoropolymer typically has a dynamic viscosity at a shear rate of 1 rad x $sec^{-1}$ and at a temperature exceeding the melting point by about 30°C, preferably at a temperature of $Tm_2$ + (30 $\pm$ 2°C) which is comprised between 10 and $10^6$ Pa $\times$ sec, when measured with a controlled strain rheometer, employing an actuator to apply a deforming strain to the sample and a separate transducer to measure the resultant stress developed within the sample, and using the parallel plate fixture.

The per(halo)fluoropolymer is advantageously thermoplastic. The term "thermoplastic" is understood to mean, for the purposes of the present invention, polymers existing, at room temperature (25°C), below their melting point if they are semi-crystalline, or below their Tg if amorphous. These polymers have the property of becoming soft when they are heated and of becoming rigid again when they are cooled, without there being an appreciable chemical change. Such a definition may be found, for example, in the encyclopaedia called "Polymer Science Dictionary", Mark S.M. Alger, London School of Polymer Technology, Polytechnic of North London, UK, published by Elsevier Applied Science, 1989.

Preferably, the per(halo)fluoropolymer is semi-crystalline. The term "semi-crystalline" is intended to denote a polymer having a heat of fusion of more than 1 J/g when measured by Differential Scanning Calorimetry (DSC) at a heating rate of 10°C/min, according to ASTM D 3418. Preferably, suitable semi-crystalline polymers have a heat of fusion of at least 3 J/g, more preferably of at least 5 J/g, most preferably at least 10 J/g.

A particular preferred group of halogenated polymers are vinylidene chloride polymers.

The expression "vinylidene chloride polymer" is understood to mean vinylidene chloride homopolymers and also copolymers. The vinylidene chloride polymer is advantageously a vinylidene chloride copolymer.

The expression "vinylidene chloride copolymer" is understood to mean copolymers of vinylidene chloride, which is the main monomer (typically, the one polymerized in the highest weight amount), with at least one co-monomer with which it is copolymerizable.

Among the co-monomers that are copolymerizable with vinylidene chloride, mention may be made, non-limitingly, of vinyl chloride, vinyl esters such as for example vinyl acetate, vinyl ethers, acrylic acids, esters and amides, methacrylic acids, esters and amides, acrylonitrile, methacrylonitrile, styrene, styrene derivatives, butadiene, olefins such as for example ethylene and propylene, itaconic acid and maleic anhydride, but also copolymerizable surfactants such as 2-acrylamido-2-methylpropanesulphonic acid (AMPS) or one of its salts, for example the sodium salt, 2-sulphoethylmethacrylic acid (2-SEM) or one of its salts, for example the sodium salt, and the phosphate ester of methacrylate-terminated polypropylene glycol (such as the product SIPOMER® PAM-200 from Rhodia) or one of its salts, for example the sodium salt.

Preferred vinylidene chloride polymers are copolymers composed of vinylidene chloride in an amount of at least 50 wt % and at least one comonomer chosen from vinyl chloride and/or at least one monomer chosen from maleic anhydride, itaconic acid and (meth)acrylic monomers corresponding to the general formula :

$$CH_2 = CR_5R_6$$

in which $R_5$ is chosen from hydrogen and the methyl radical and $R_6$ is chosen from the -CN radical and the -CO-$R_7$ radical in which $R_7$ is chosen from the -OH radical, -O-$R_8$ radicals with $R_8$ chosen from the linear or branched alkyl radicals containing from 1 to 18 carbon atoms optionally bearing one or more -OH radicals, the epoxyalkyl radicals

containing from 2 to 10 carbon atoms and the alkoxyalkyl radicals containing a total of 2 to 10 carbon atoms and finally $R_8$ is also chosen from the $-NR_9R_{10}$ radicals in which $R_9$ and $R_{10}$, which are the same or different, are chosen from hydrogen and the alkyl radicals containing from 1 to 10 carbon atoms, optionally bearing one or more -OH radicals, the aforementioned copolymerizable surfactants and the phosphate ester of methacrylate-terminated polypropylene glycol or one of its salts, for example the sodium salt.

Particularly preferred vinylidene chloride polymers are copolymers composed of vinylidene chloride in an amount of at least 50 wt % and at least one comonomer chosen from vinyl chloride and/or at least one monomer chosen from the (meth)acrylic monomers corresponding to the general formula :

$$CH_2 = CR_5R_6$$

in which $R_5$ is chosen from hydrogen and the methyl radical and $R_6$ is the $-CO-R_7$ radical in which $R_7$ is chosen from the -OH radical, $-O-R_8$ radicals with $R_8$ chosen from linear or branched alkyl radicals containing from 1 to 18 carbon atoms optionally bearing one or more -OH radicals, epoxyalkyl radicals containing from 2 to 10 carbon atoms and alkoxyalkyl radicals containing a total of 2 to 10 carbon atoms.

The vinylidene chloride polymer is more particularly preferably a copolymer composed of vinylidene chloride in an amount of at least 50 wt % and at least one co-monomer chosen from the (meth)acrylic monomers corresponding to the general formula:

$$CH_2 = CR_5R_6$$

in which $R_5$ is chosen from hydrogen and the methyl radical and $R_6$ is the $-CO-R_7$ radical in which $R_7$ is chosen from the -OH radical and $-O-R_8$ radicals with $R_8$ chosen from linear or branched alkyl radicals containing from 1 to 18 carbon atoms optionally bearing one or more -OH radicals, epoxyalkyl radicals containing from 2 to 10 carbon atoms and alkoxyalkyl radicals containing a total of 2 to 10 carbon atoms.

Among the co-monomers corresponding to the general formula

$$CH_2 = CR_5R_6$$

mention may be made of methyl acrylate, methyl methacrylate, ethyl acrylate, ethyl methacrylate, n-butyl acrylate, n-butyl methacrylate, 2-ethylhexyl acrylate, 2-ethylhexyl methacrylate, 2-hydroxyethyl acrylate, 2-hydroxyethyl methacrylate, glycidyl methacrylate, glycidyl acrylate, acrylic acid and methacrylic acid.

The vinylidene chloride polymer is particularly preferably a copolymer derived from vinylidene chloride in an amount of at least 50 wt % and at least one comonomer chosen from methyl acrylate, methyl methacrylate, ethyl acrylate, ethyl methacrylate, n-butyl acrylate, n-butyl methacrylate, 2-ethylhexyl acrylate and 2-ethylhexyl methacrylate.

One vinylidene chloride polymer according to the invention that gives very good results is a copolymer derived from vinylidene chloride in an amount of at least 50 wt % and methyl acrylate.

Advantageously, the amount of vinylidene chloride in the vinylidene chloride copolymers varies from 50 to 95 wt %, preferably from 60 to 95 wt %, particularly preferably from 70 to 95 wt % and more particularly preferably from 80 to 95 wt %.

Advantageously, the amount of vinyl chloride in the vinylidene chloride copolymers varies from 0.5 to 50 wt %, preferably from 5 to 40 wt %, particularly preferably from 5 to 30 wt % and more particularly preferably from 5 to 20 wt %.

Advantageously, the amount of methyl acrylate in the vinylidene chloride copolymers varies from 5 to 50 wt %, preferably from 5 to 40 wt %, particularly preferably from 5 to 30 wt % and more particularly preferably from 5 to 20 wt %.

The core/shell particles forming component b) of the polymer compositions in accordance with the instant invention comprise at least one core and a shell.

By definition a core/shell particle comprises a core component and a shell component which differ in their chemical composition. As a result of the difference in chemical composition the core and the shell materials constitute distinct phases which can be distinguished by suitable techniques.

For the purpose of the instant invention, the term core/shell indicates any material wherein two distinct phases are discernible by appropriate analytical techniques and where one of the materials envelops the other material. In other words, core/shell particles are particulate systems comprising at least two particulate components having distinct chemical composition assembled in such a way that they form a continuous system wherein a first particulate material (hereinafter referred to as the shell) envelops or encapsulates a second particulate material (hereinafter referred to as core) directly or through an intermediate layer of a third particulate material.

For the purposes of the instant invention the term core/shell particles may include, without being limited to, several alternate structures.

Thus, as a first example, core/shell particles consist of one or several cores fully enveloped by a shell layer

forming basically the outer wall of the particles. Between the core and the shell there may be intermediate layers separating core and shell from direct contact but overall the shell envelops the core part completely, including the intermediate layer. Such intermediate layer may form an interphase between the core and the shell and can be of any composition.

Preferably this intermediate layer, if present, may have an intermediate composition (intermediate between the core and the shell in composition) and can be uniform throughout the interphase or may form a composition gradient gradually changing from the composition of the core to the composition of the shell.

In yet another form the core/shell particle may have a structure wherein the shell layer contains voids while yet fully enveloping the core or cores.

Figure 1 shows an exemplary selection of a number of core/shell geometries of particles included in the definition of core/shell particles in accordance with the instant invention.

Thus, figure 1a) shows a continuous core/shell microcapsule in which a single continuous shell surrounds a continuous region of core material.

Figure 1b) is an example of a core/shell particle in the form of a multinuclear microcapsule in which a number of small domains of core particles are distributed throughout a matrix forming the shell. As can be seen, the shell fully envelops all core particles.

Figure 1c shows a continuous core capsule which is encapsulated by one or more shell(s) and separated by a transition region forming an interphase of intermediate composition between that of the core and the shell materials.

Figure 1d) shows a continuous capsule of shell material encapsulating one or more domains of core particles wherein the shell comprises voids.

All the core/shell particles described hereinbefore may be named "perfect" core/shell particles, characterized by the common feature that the shell fully envelops the core or in the case of multiple cores or core particles, the cores as a whole.

These so called perfect core/shell particles are preferred as component b) in the polymer compositions in accordance with the instant invention.

Besides the perfect core/shell particles it is also possible to use, in accordance with the instant invention, core/shell particles where the shell does not envelop the core or cores in its entirety. Though not preferred in accordance with the instant invention, such imperfect core/shell particles are nevertheless also suitable and covered by the term core/shell particle as used herein.

The core shell particles in the polymer composition comprise at least one compound C1 of a metal M1 in the core and at least one compound C2 of a metal M2 in the shell.

The compounds C1 are selected from the group of oxides, oxyfluorides, oxyhydroxyfluorides and mixtures thereof. C2 can be, independently from C1, selected from the same group and in addition can also be a fluoride. Oxyhydroxyfluorides may be represented by the general formula $MO^{a+}(OH)_xF_{a-x}$ wherein a represents the valency of MO. $TiO(OH)_{0.4}F_{1.6}$ may be mentioned as an example for an oxyhydroxyfluoride of $TiO^{2+}$. Oxyhydroxyfluorides can vary in composition over a broad range, i.e. there are no specific limitations for the value of x.

C1 or C2 encompass physical blends of oxides, oxyfluorides or oxyhydroxyfluorides (in addition also fluorides in C2) of different metals M1 or mixed oxides, oxyfluorides or oxyhydroxyfluorides with different metals M1 or M2.

Furthermore C1 and/or C2 can further include metals other than M1 or M2, in particular in the form of their oxides, oxyfluorides or oxyhydroxyfluorides or, in the case of C2 in the form of fluorides (hereinafter referred to as C1' and C2', respectively).

In an alternative embodiment C1 and/or C2 can be doped with different metals.

In addition to C1 and C2 (and, eventually C1' and C2') the core/shell particles may include ingredients like surfactants and tensides, i.e. additives which are commonly used to steer the desired properties of particles used as fillers in polymer compositions.

According to a first embodiment the core/shell particles comprise at least one core composed of one compound C1.

According to a second embodiment, the core comprises (and preferably is composed of), in addition to C1, an oxide, oxyfluoride or oxyhydroxyfluoride or a mixture thereof of a metal different from M1.

In a third embodiment the compound C1 comprises, preferably is composed of, at least one metal M1, and at least one additional metal different from M1, C1 being selected as above from the group consisting of mixed oxides, oxyfluorides and oxyhydroxyfluorides of said at least two metals.

According to another embodiment, two compounds C1 and C1' are present in the at least one core, C1 being an oxide, oxyfluoride or oxyhydroxyfluoride of a metal M1 and C1' a respective compound of a metal M1' different from M1. Preferably the at least one core is composed of the two compounds in this embodiment.

A further exemplary embodiment is a combination of a compound C1 selected from oxides, oxyfluorides and oxyhydroxyfluorides of a metal M1 and a compound C1' selected from oxides, oxyfluorides and oxyhydroxyfluorides comprising two metals, M1 and a metal M1' different from M1.

The foregoing embodiments are only intended to give a number of variations on the core/shell particles used in the polymer compositions in accordance with the instant invention. The man skilled in the art is aware of further possibilities how the at least one core of the core/shell particle can be composed.

Furthermore, equivalent variations as indicated above can be present in the shell of the core/shell particles, i.e. the shell can also comprise different compounds of different metals, mixed compounds comprising two metals etc. as outlined above.

The metal M1 is selected from the group consisting of Zn, Ti, Zr or Ce and their mixtures. Oxides, oxyfluorides and oxyhydroxyfluorides of these metals are known in the art and described in the literature so that there is no detailed description necessary here. Suitable products are commercially available from a number of sources. Only by way of example, ZnO, $CeO_2$, $TiO_2$ and $TiOF_2$ shall be mentioned here.

Generally the oxides, oxyfluorides and oxyhydroxyfluorides of these metals possess good UV-absorbing properties, i.e. they can be used as UV-absorbers in the polymer compositions in accordance with the instant invention. Due to the application areas of polymer compositions in areas where a high UV-radiation is present, a good UV-protection of such compositions is important.

If a compound of another metal is present in the at least one core, this metal can basically be selected from any metal of the periodic system of the elements other than the metal M1. Suitable metals and respective compounds thereof in the boundaries as defined in the claims and explained hereinbefore are known to the skilled man and described in the literature. Many suitable products are commercially available from a number of sources.

The metal M2 is selected from the group consisting of Si (Si being considered as a metal for the purposes of the instant invention), Mg, Ca, Sr and mixtures thereof. Oxides, fluorides, oxyfluorides and oxyhydroxyfluorides of these metals are known in the art and described in the literature so that there is no detailed description necessary here. Suitable products are commercially available from a number of sources. By way of example, $SiO_2$, $MgF_2$ and $CaF_2$ may be mentioned here. The variations of the composition of the shell in accordance with the forgoing exemplary alternatives or equivalent substitutes are evident for the skilled man.

Again, if the shell comprises, in accordance with a respective embodiment, a compound of at least one other metal or comprises two metals in one compound, said other metal may be selected from any metal of the periodic system of the elements and suitable compounds are known to the skilled man.

The ratio of the metal M1 of the core to the metal M2 in the shell is in the range of from 0.1:1 to 1.7:1, preferably of from 0.2:1 to 1.1:1, most preferably in the range of from 0.25:1 to 0.8:1. By using the known specific density of the materials this atomic ratio translates into a certain thickness ratio of core and shell and by using the molecular weight of the core and shell materials the respective mass percentages can be easily calculated.

It has surprisingly been found that selecting the molar ratio in the aforementioned range unexpected beneficial properties are observed when such core/shell particles are used as fillers in polymer compositions. The combination of particle size and atomic ratio of the metals in core and shell in accordance with the instant invention improves dispersibility of the materials in polymer matrices combined with improved end-use properties of the polymer materials such as homogeneity and transparency.

Surprisingly, it has been found that the most preferred atomic ratio is rather independent from the shell metal, i.e. the nature of the shell metal (or shell compound) is less important on the optimum atomic ratio than the nature of the core metal. Thus, it has been found that a very preferred range of atomic ratios for ZnO as core material (i.e. Zn as core metal) is in the range of from 0.3:1 to 0.9:1, most preferred in the range of from 0.3:1 to 0.8:1 (always molar ratio core : shell metal) for any of the shell materials $SiO_2$, $MgF_2$, $CaF_2$ and $SrF_2$. If ZnO is replaced by $TiO_2$ (i.e. Ti as core metal), the preferred range is from 0.1:1 to 0.4:1 and particularly preferred of from 0.15:1 to 0.35:1. For $CeO_2$ (i.e. Ce as core metal) as core the preferred ratios are 0.3:1 to 0.75:1 and most preferred of from 0.35:1 to 0.7:1. Finally, for $TiOF_2$ the most preferred ranges are 0.3:1 to 0.7:1, especially 0.35: 1 to 0.6:1.

The molar ratio of the metals M1 and M2 is advantageously predetermined by the synthesis recipe and can be experimentally verified on dry powders by X-ray fluorescence. Respective techniques as well as methods for a suitable preparation of the samples for such measurements are well known to the man skilled in the art. The following describes one suitable procedure for such measurements in more detail.

A suitable instrument for carrying out respective measurements is a wavelength-dispersive X-ray spectrometer as e.g. available from Philips under the designation PW2404.

For the evaluation of the measurement and the calculation of the respective values, a commercially available analysis procedure as e.g. a panoramic analysis procedure commercially available as UNIQUANT® (Version 4m, available from Omega Data Systems) may be used. To the extent necessary, the instruction manual of UNIQUANT®, Version 4 is incorporated herein by reference.

Prior to the actual measurements, according to good laboratory practice sensitivity variations of the instrument compared to the initial calibration can be compensated by measuring the responses of control samples (sensitivity measures).

The samples for the measurement are usually provided in the form of dry powders, i.e. if the particles are

originally in the form of a dispersion in the liquid medium, the material is isolated from the liquid medium and dried.

For analysis, suitable amounts of the respective powders are embedded e.g. between polypropylene films of appropriate thickness for analysis.

The raw results, if necessary, are corrected to account for matrix effects such as absorption and for spectral interferences. Suitable corrections are proposed e.g. in the UNIQUANT® procedure referred to above.

The measurement yields the weight ratios of the respective metals which can easily be converted into a molar weight ratio.

The core/shell particles in the polymer compositions of the instant invention have an average particle diameter of less than or equal to 300 nm, preferably of less than or equal to 200 nm and more preferably of less than or equal to 150 nm. In certain cases it has proven advantageous if the average particle diameter is less than 100 nm, particularly preferred less than 50 nm. Normally, the average particle diameter is at least 1 nm, or in some cases at least 3 nm.

The term average particle diameter when used herein refers to the $D_{50}$ median diameter computed on the basis of the intensity weighed particle size distribution as obtained by the so called Contin data inversion algorithm. Generally said, the $D_{50}$ divides the intensity weighed size distribution into two equal parts, one with sizes smaller than $D_{50}$ and one with sizes larger than $D_{50}$.

In general the average particle diameter as defined above is determined according to the following procedure. First, if needed, the core/shell particles are isolated from a medium in which they may be contained (as there are various processes for the manufacture of core/shell particles, the products may be available in different forms, e.g. as neat dry particles or as a suspension in a suitable dispersion medium. The neat core/shell particles are then used for the determination of the particle size distribution preferably by the method of dynamic light scattering. In this regard the method as described in ISO Norm Particles size analysis - Dynamic Light Scattering (DLS), ISO 22412:2008(E) is recommended to be followed. This norm provides i.a. for instructions relating to instrument location (section 8.1.), system qualification (section 10), sample requirements (section 8.2.), measurement procedure (section 9 points 1 to 5 and 7) and repeatability (section 11). Measurement temperature is usually at 25 °C and the refractive indices and the viscosity coefficient of the respective dispersion medium used should be known with an accuracy of at least 0.1 %. After appropriate temperature equilibration the cell position should be adjusted for optimal scattered light signal according to the system software. Before starting the collection of the time autocorrelation function the time averaged intensity scattered by the sample is recorded 5 times. In order to eliminate possible signals of dust particles moving fortuitously through the measuring volume an intensity threshold of 1.10 times the average of the five measurements of the average scattered intensity may be set. The primary laser source attenuator is normally adjusted by the system software and preferably adjusted in the range of about 10,000 cps. Subsequent measurements of the time autocorrelation functions during which the average intensity threshold set as above is exceeded should be disregarded.

Usually a measurement consists of a suitable number of collections of the autocorrelation function (e.g. a set of 200 collections) of a typical duration of a few seconds each and accepted by the system in accordance with the threshold criterion explained above. Data analysis is then carried out on the whole set of recordings of the time autocorrelation function by use of the Contin algorithm available as a software package, which is normally included in the equipment manufacturer's software package.

Certain core/shell particles representing preferred embodiments for the compositions in accordance with the instant invention are described now as exemplary for suitable core shell particles.

A first group of core/shell particles comprise at least one core, said core comprising (and even more preferably consisting essentially of) at least one inorganic compound C1 composed of at least one metal M1, at least one element E1 and, optionally, at least one metal M1', wherein the metal M1 is selected from the group consisting of Zn, Ti, Zr, Ce and mixtures thereof, said element E1 is selected from the group consisting of oxygen, fluorine, hydrogen and mixtures thereof and said metal M1', if present, is any metal other than the metals M1, said component C1 thus being selected from the group consisting of the oxides, oxyfluorides or oxyhydroxyfluorides of the metals M1, optionally in combination with a metal M1'. Mixtures of different compounds C1 can be used.

If a metal M1' is present it can be present as a dopant in compound C1 or it can be present as a compound C1' composed of at least one metal M1' and at least one element E1', wherein E1' is selected from the group consisting of oxygen, fluorine, hydrogen and mixtures thereof and thus said compound C1' being selected from the group consisting of the oxides, oxyfluorides or oxyhydroxyfluorides of the metals M1'.

Furthermore, it is possible that the at least one core comprises metal M1' in compound C1 (e.g. as dopant) as well as in the form of a compound C1'.

In a similar manner as described above for the at least one core, the shell of the core/shell particles suitable for use in the compositions in accordance with the instant invention comprises (and preferably consists essentially of), in accordance with another embodiment, at least the inorganic compound C2 composed of at least one metal M2, one element E2 and, optionally, at least one metal M2'. The metal M2 is selected from the group consisting of Si, Mg, Ca, Sr and mixtures thereof, E2 is selected from the group consisting of oxygen, fluorine, hydrogen and mixtures thereof and said metal M2' is any other metal than metal M2 (preferably selected from the group consisting of boron, aluminum,

sodium, lithium, potassium and mixtures thereof) and compound C2 is thus selected from the group consisting of the oxides, fluorides, oxyfluorides and oxyhydroxyfluorides of the metal M2, optionally in combination with metal M2'. For the purpose of the instant invention, boron is considered to be a metal. Mixtures of different compounds C2 can be used.

If a metal M2' is present it can be present as a dopant in compound C2 or it can be present as a compound C2' composed of at least one metal M2' and at least one element E2', wherein E2' is selected from the group consisting of oxygen, fluorine, hydrogen and mixtures thereof and thus said compound C2' being selected from the group consisting of the oxides, fluorides, oxyfluorides or oxyhydroxyfluorides of the metals M2'.

Furthermore, it is possible that the at least one core comprises metal M2' in compound C2 (e.g. as dopant) as well as in the form of a compound C2'.

Cores and shells as described above can be combined in any possible form to yield core/shell particles suitable for use in the polymer composition in accordance with the instant invention.

Various techniques have been developed and described in the literature to synthesize nanoparticulate core/shell particles. Precipitation, grafted polymerization, micro emulsion, reverse micelle sol-gel condensation or layer-by-layer adsorption techniques can be mentioned as suitable methods to achieve the desired structure.

For the purposes of the instant invention, synthesis methods achieving as much as possible a complete enveloping of the core or the cores by the shell are preferred.

According to one approach core and shell particles are synthesized separately and in a second step, the shell particles are anchored to the core particles by appropriate procedures. According to a preferred embodiment of this approach, the surface of the core particles is modified with bifunctional molecules to enhance the coverage of shell material on their surface. Through the bifunctionality of the modifying agents, core and shell particles are bonded together.

According to a similar approach, described in Langmuir, 2003, 19, 6993-7000, colloidal particles are functionalized on their surface with polyvinyl pyrrolidone (PVP), an amphiphilic non-ionic polymer.

It is also possible to make core/shell nanoparticles without functionalizing the core particles through chemicals. For example, opposite electrical charges can be developed on the core and shell particles which are then coupled together by electrostatic attraction (Adv. Funct. Mat. 2004, 14, 1089-1095).

A preferred approach for the synthesis of the core/shell particles in accordance with the instant invention is the so-called controlled precipitation. The synthesis of the shell material is carried out in the presence of the core particles. The core particles act as nuclei and hydrolysed shell material gets condensed on these cores. Through the concentration of the reactants and the amount of core shell/particles the shell thickness can be controlled.

In another technique, known as so-called layer-by-layer technique alternating layers of anionic particles and cationic particles are deposited on a surface modified template molecule by heterocoagulation. Such methods lead to the formation of homogeneous and dense coatings.

The reactants for the aforementioned processes can be produced in a "top-down" process from larger particles (i.e., grinding) or a "bottom-up" process from smaller particles (atoms, molecules). Nanophase Technologies Corporation USA has developed a vapour phase plasma synthesis referred to as Physical Vapour Synthesis (PVS) and NanoArc™ Synthesis (NAS). According to this method, metals or metal oxides (as powders or as solid rods) are fed into a reactor where plasma energy is used to generate a vapour at high temperature. A reactant gas such as oxygen (air) is added. Immediately afterwards, the vapour is cooled at a controlled rate and nanoparticles are formed.

Due to their non-porous structure and controlled surface chemistry, nanoparticles synthesized by the vapour phase plasma process are easy to disperse in liquid media, and the resulting dispersions are highly stable, low viscosity (even at higher concentrations) and therefore easy to handle. Chemically there is a wide variety of nanoparticles that can be manufactured using the described methods. Examples are ZnO as well as $CeO_2$ particles for UV protection.

A concise review on the manufacture of nano-sized core/shell particles is given in Kalele et al., Current Sci. Vol. 91, No. 8, (2006).

Atou et al., Physica E 16, 2003, 179-189 discloses a method for the preparation of silicon oxide layers on $TiO_2$ particles and Siddiquey et al., Applied surface sci. 255 (2008), 2419-2424 describe the silica coating of $CeO_2$ nanoparticles by a fast microwave irradiation method.

WO 2008/019905 mentioned hereinbefore also describes methods for the manufacture of nanoparticulate core/shell particles.

The principles of the aforementioned methods for specific products can be applied for other core/shell particles having a different core and/or a different shell.

Thus, suitable methods for the manufacture of the core/shell particles in accordance with the instant invention are known per se and described in the literature so that further details are not necessary here.

Just by way of example, a description of a suitable process for $CeO_2$-$SiO_2$ core/shell particles shall be given in some more detail here, using sodium silicate as the silica precursor. A dilute dispersion of $CeO_2$ nanoparticles is prepared in water so as to target a $CeO_2$ content of 5 wt%, based on the total weight of the dispersion. This dispersion may contain dispersing agents such as surfactants or other additives and it might be necessary to use appropriate dispersion methods including e.g. ultrasound or high-shear liquid dispersion methods for an appropriate time. To stabilize

the colloidal system it might be necessary to adjust the pH of the dispersion to a range in which the metal oxide particles are colloidally stable by electrostatic repulsion of their surface charges (it has to be noted, however, that this approach may be limiting in the subsequent processing steps as further steps may include adjusting the pH in a way that the system is destabilized). The dispersion may for example be the result of a direct synthesis approach in which $CeO_2$ is generated in situ, or from the redispersion of solid $CeO_2$ particles or form the use of a stable aqueous $CeO_2$ dispersion.

To this aqueous dispersion a sodium silicate dispersion comprising e.g. appr. 8 wt% of $Na_2O$ and appr. 27 wt% of $SiO_2$ is added dropwise under vigorous mechanical stirring. The pH of the mixture should be adjusted at a value of approximately 9. Once all reagents have been added, the mixture is set to react to almost completion at room temperature under vigorous stirring for e.g. 24 hours. Appropriate care should be taken to avoid the evaporation of solvent, which can easily be achieved by using a sealed reaction vessel obtainable from laboratory suppliers.

Subsequent to completion of the reaction, a stable or easily dispersible suspension of silica-coated $CeO_2$ particles is obtained which may optionally be purified by repeated dilution with deionized water followed by sedimentation and removal of the supernatant.

Instead of using sodium silicate as the Si-precursor other sources can be used, e.g. tetraethyl orthosilicate (TEOS) commercially available. In this case, the core material may be dispersed in a mixture of TEOS and ethanol under ultrasonic grinding. Addition of de-ionized water and ammonia and suitable pH adjustment allows for the subsequent reaction to take place, under e.g. sonication for an appropriate time. The ethanol may then be removed from the system along with the water, if required, to obtain the desired product.

According to a particular embodiment, the core/shell particles b) are coated and/or grafted, i.e. the outer surface of the shell is modified by the coating and/or grafting thereon of suitable compounds. Among such suitable compounds, it can be notably cited $C_{12}$-$C_{24}$ carboxylic acids (such as stearic acid), higher fatty acids and waxes or their derivatives (e.g. their esters such as the triglycerides), fluorinated compounds like perfluorinated or partially fluorinated $C_{12}$-$C_{24}$ carboxylic acids or alcohols, perfluorinated or partially fluorinated higher fatty acids or higher alcohols; and organic siliconcompounds such as silicone oils, organic alkoxysilanes, organic chlorosilanes or silazanes, with a particular interest for silanes and alkoxysilanes. Coated and/or grafted core/shell particles have been found advantageous in a number of cases, especially when the polymer composition is prepared by melt-processing.

Suitable silicone oils and silanes include in particular dimethylpolysiloxanes, methylhydrogenpolysiloxanes, methylphenylsiloxanes and cyclic polydimethylsiloxanes.

Suitable modified silicon oils may be alkyl-modified, polyether-modified, amino-modified, mercapto-modified, epoxy-modified and fluorine modified.

Exemplary alkoxysilanes are vinyltrichlorosilane, vinyltrimethoxysilane, vinyltriethoxysilane, (methacryloyloxypropyl)triethoxysilane, chloropropyltrimethoxysilane, aminopropyltrimethoxysilane, aminopropylmethyldimethoxysilane, aminopropyltriethoxysilane, methyltrimethoxysilane, dimethyldimethoxysilane, and trimethylmethoxysilane. Suitable alkoxysilanes may also carry a perfluorinated or partially fluorinated alkyl group with 1 to 12, preferably 1 to 10 carbon atoms. As an example perfluorooctyltriethoxysilane may be mentioned here.

Methods for coating of core/shell particles are known per se and described in the literature. For example, the agent to be coated onto the core shell/particle is added to a dispersion of the core/shell particle in water or in an organic solvent or in a organic solvent/water mixture, and the mixture is stirred ; alternatively, the core shell/particle is added to a medium (e.g. a solution) comprising either water and/or an organic solvent on one hand, and the coating agent on the other hand, and the medium is stirred.

Methods for grafting of core/shell particles are also known per se and described in the literature.

According to one method, often referred to as wet method, the compound to be grafted onto the core shell/particle is added to a dispersion of the core/shell particle in water or an organic solvent or in a solvent/water mixture, preferably in the presence of a reaction catalyst and the mixture is stirred.

Alternatively, the core/shell particle can be stirred in a vessel equipped with a mixer (e.g. a Henschel mixer or the like) and the grafting agent can be added by way of spraying or similar means. Preferably, a catalyst is furthermore added to the vessel to promote the grafting reaction. Thereafter mixing is continued to allow the grafting agent to be grafted onto the surface of the core/shell particle. Further details of suitable processes are e.g. disclosed in WO03/104319.

A preferred process for the manufacture of grafted core/shell particles useful in the compositions of the present invention may be described as follows: the core particle is dispersed in a suitable solvent as e.g. water or ethanol or a mixture thereof, and stirred. If necessary, particle size may be reduced by sonication or grinding in suitable solvent, the material forming the shell is added, if necessary together with a suitable catalyst for the precipitation of the shell onto the core particle. Sonication may be used to prevent gel formation or agglomeration, if necessary.

The core/shell particles thus obtained may be grafted as follows: to a dilute solution of the core/shell particle in a suitable solvent, e.g. an ethanol/water mixture or the like, eventually containing additives promoting or catalyzing the condensation of the grafting agent a solution of the grafting agent in a suitable solvent is added. Dropwise addition, i.e. slow addition may be advantageous. The system is stirred for an appropriate time, typically in the range of several hours, e.g. 12 to 48 h and thereafter the grafted core/shell particle is flotated. Flotation may be repeated several times

to separate non-grafted material from the grafted material and the grafted core/shell particles may thereafter be recovered and dried.

The weight percentage of the core/shell particles in the polymer composition in accordance with the instant invention is at least 0.1 wt%, based on the weight of the polymer, preferably at least 0.3 wt.% based on the weight of the polymer, preferably 1 wt.% based on the weight of the polymer. The polymer composition may contain up to 100 wt%, based on the weight of the polymer, of a core/shell particle. Usually, the content of the core/shell particle is at most 75 wt%, more preferably at most 50 wt%, based on the weight of the polymer.

In certain embodiments in accordance with the present invention, the core/shell particles are coated without being grafted, grafted without being coated, or grafted and coated together (e.g. when using a combination of a coating agent such as a higher fatty acid and a grafting agent such as an alkoxysilane).

While the incorporation into the polymer composition of core/shell particles b) that have been coated and/or grafted has been found advantageous in a number of cases as above described, good results have also been obtained by incorporating into the polymer composition core/shell particles b) that that have neither been coated nor grafted, especially when the polymer composition is prepared by the subsequently described aqueous mixing process.

The incorporation of the core/shell particles into the polymer composition may be achieved in different ways.

The process may be an aqueous mixing process according to which the polymer and the core shell particle are mixed in an aqueous system. Such procedure has been found advantageous for halogenated polymers, e.g. vinylidene chloride polymers or fluoropolymer lattices and non-grafted core/shell particles, albeit the core/shell particles may also be grafted.

In an alternative variant, the core/shell particle and the polymer are mixed in a melt phase process, e.g. by melt extrusion or a similar process. Such process is usually advantageous for polymers like poly(arylene polyethers) like e.g. polysulfone, polyphenylsulfone or polyethersulfone or polyimides or thermoprocessible fluoropolymers, in particular when using grafted core/shell particles (albeit this process may also be used with non-grafted core/shell particles).

The polymer compositions in accordance with the instant invention comprising the aforementioned polymers and the nanoparticulate core/ shell particles in accordance with the instant invention show an advantageous profile of properties which make them particularly useful for certain applications. The core/shell particles show a good dispersibility in the polymer matrices. Due to their core/shell nature, the photocatalytic activity of the core materials is advantageously reduced, which is beneficial for the long term stability and properties of the polymer compositions. As has been surprisingly found, the core/shell materials in accordance with the instant invention also are advantageous in maintaining a good degree of transparency of the polymer compositions where transparent polymers are used as the matrix material.

The term transparent is used herein to describe a composition and/or an article is able to transmit image-forming light. The distinctness of the image transmitted through the composition may be used as a measure of transparency. In one sense, transparency depends on the linearity of the passage of light rays through a composition or article.

Generally, when light interacts with matter, it can be reflected, absorbed, scattered, and/or transmitted. A composition or article is generally described as "transparent" if a significant fraction of incident light is transmitted through the composition or article. An object is considered "opaque" if little or substantially no light is transmitted through it. An object is considered "translucent" if some light passes through but not in a way that a coherent image can be seen through it or transmitted through it. Typically, translucence occurs when light takes a circuitous path through the composition or article, e.g. as a result of scattering due to embedded particles, defects or grain boundaries in the composition or article.

The inventive compositions may be described as transparent to visible light when (1) not reflecting significant amounts of incoming light at the incident surface (i.e., advantageously less than 50 %, preferably less than 30 %), (2) not absorbing significant amounts of incoming light (i.e., advantageously less than 50 %, preferably less than 30 %), and (3) not scattering significant amounts of said incoming visible light (i.e., advantageously less than 50 %, preferably less than 30 %).

According to ASTM D 1746 (incorporated herein by reference in its entirety), transparency can be determined by small-angle light scattering. A light source emits a light radiation which is passed though a collimator to guide incident beam towards the sample specimen; intensity of incident light beam $I_i$ and of transmitted light deflected by less than 0.1 degree $I_r$ is measured; an aperture avoids reflected and scattered or deflected light to reach the detector.

Transparency is thus expressed as a percentage according to the following equation :

$$\%T = \frac{I_r}{I_i} \times 100 .$$

The compositions of the invention may themselves be transparent or can be made into articles (e.g. by extrusion or injection moulding or coating methods) having a level of transparency of advantageously more than 40 %, preferably

of more than 50 %, more preferably more than 60 %, still more preferably of more than 65 %, even more preferably of more than 70 %, especially preferably more than 80 % of the transparency of the unfilled article respectively polymer not containing core/shell particles as measured according to ASTM D 1746, when measured on sheets having a thickness of 100 μm.

In the case of liquid phase systems (typically polymer emulsions of e.g. polyvinylidene chloride or fluoropolymers) the low point of zero charge of silica (a preferred shell material) allows to improve the colloidal stability of the core material in the dispersion medium in the pH range of interest for the intended uses. Grafting of alkoxysilanes in such systems may be a way to adjust the surface properties of the core/shell particles for better compatibility with the polymer or the liquid medium.

In the case of melt processable polymers, grafting of the core/shell particles is an elegant way to adjust the surface properties of the matrix and to improve the compatibility and dispersibility of the core/shell particles in the polymer medium.

The polymer compositions in accordance with the instant invention may comprise, in addition to components a) and b) other additives known to the skilled man for respective polymer compositions. Only for the purpose of giving examples, dispersing agents, processing aids and the like may be mentioned. Suitable additives are known to the skilled man as well as the amount in which such additives are commonly used. If present, additives not detrimentally influencing the transparency as defined above are preferred.

Due to their combination of properties the polymer compositions in accordance with the instant invention are particularly useful for use in the photovoltaic industry, and the food and medical packaging industry.

Photovoltaic modules need a stable packaging system to produce electricity from fragile e.g. crystalline silicon wafers. Fluoropolymer films have played and continue to play multiple roles in the photovoltaic module package. Photovoltaic modules by their nature need to be exposed to as much sunlight as possible. Therefore the materials used to support and protect the modules must be up to the task of such exposure. The silicon wafers and associated electrical connections are usually embedded in a crosslinked ethyl vinyl acetate (EVA) matrix (the crosslinking process takes place together with the lamination process of the Photovoltaic's module, a process that glues all the active and protective materials and which is usually a vacuum process at around 150°C for about 20-30 minutes). The side of the module incident to solar radiation nowadays is most often glass. The glass provides durability, rigidity and clarity. However, glass has a weight disadvantage and the risk of breaking is also detrimental. As there is an increasing trend to make larger photovoltaic arrays that provide higher energy densities and lower cost, thinner and lighter polymer films are interesting. However, most common polymer compositions are inadequate because of the extreme requirement of clarity or transparency with long outdoor life. The polymer compositions in accordance with the instant invention, in particular those based on fluoropolymers exhibit a particularly advantageous property spectrum for such uses (combination of transparency and UV-stability).

Polymer compositions in accordance with the instant invention may also be advantageously used for the backside of photovoltaic modules.The backside of the module is usually covered with a backing layer most often composed of polymer films and laminates. Functionally the backing layer provides physical protection, electrical insulation, moisture protection and in some circumstances unique color identification all while adhering to the encapsulant over the life of the module [>25 years for rigid glass based PV modules].

Example 1 - Preparation of a grafted $CeO_2/SiO_2$ core shell particle.

50 grams $CeO_2$ (Adnano® 60 $CeO_2$ from Evonik) were mixed with 965 grams of ethanol and well stirred. Thereafter the dispersion was sonicated for 30 minutes, after which 43.6 grams of tetraethoxysilane (TEOS) were added under vigorous stirring. 1509 grams of water and 71.3 grams of aqueous ammonia were added under vigorous stirring. The volume was distributed over 7 flasks of 250 ml each and same were put into an ultrasonic bath for 6 hours with parallel cooling to avoid heating. The reactor was fed with the 7 dispersions thus obtained and stirred for about ten minutes. A dispersion of the core/shell polymer was obtained.

Grafting step:

1428,5 ml of the dispersion containing the core shell/particles obtained as described before were put into a reactor and 1603 ml of Ethanol were added as an aerosol at 250 ml/h over 6.5 hours. This resulted in a water/ethanol mixture in the weight ratio of 25/80. The mixture was put under vigorous stirring (vortex stirrer) and 400 drops of 37 wt% hydrochloric acid (40 ml) were added dropwise over two hours.

In a separate flask a solution of 10 grams of perfluorooctyltriethoxysilane in 400 ml ethanol was prepared.

The fluorosilane solution was added dropwise to the solution of the core/shell particles and subsequently stirred with a vortex stirrer for 24 hours. After the stirring had been stopped, deionized water was added which led to the flotation of the grafted core/shell particles. The liquid phase was collected through a reactor valve to keep only the flotated fraction.

The procedure was repeated using the solid recovered fraction by adding deionized water to further remove the non-grafted fraction which decanted at the bottom. Thereafter the bottom fraction was eliminated and the core/shell particles were recovered. The powder thus obtained was dried in a freeze dryer for 48 hours and thereafter dried for 4 hours under vacuum at a temperature of 60 °C.

Example 2 - PVDC compositions containing grafted core shell/particles

A polyvinylidene chloride emulsion having a number average molecular weight of, available from SolVin as DIOFAN® A736 was mixed with an aqueous dispersion of core/shell particles as obtained from a procedure described in Example 1 before grafting, in an amount so as to target a core/shell solids content of 5 wt% in the final dried PVDC/core/shell composition, and with other particles as set forth in Table 2. All particles had a particle size well below 300 nm. Transparency was determined in accordance with ASTM D 1746 at films with a thickness of 100 μm. Haze was determined in accordance with ASTM D 1003.

The results are given in Table 2.

Table 2

| Example | Particle | Transparency (%) | Haze (%) |
|---|---|---|---|
| 2C* | none | 54.1 | 2.86 |
| 3C | $CeO_2$ Byk[1] | 42.1 | 3.91 |
| 4 | $CeO_2$ Byk CS $Na_2SiO_3$[2] | 45.5 | 3.41 |
| 5C* | $CeO_2$[3] Evonik | 9.7 | 15.6 |
| 6 | $CeO_2$ EvonikCS[4] | 44.2 | 5.92 |
| 7 | $CeO_2$ Evonik CS[5] | 55.6 | 5.98 |
| 8C* | $TiO_2$[6] | 3.8 | 13.4 |
| 9 | $TiO_2$ CS[7] | 56.9 | 8.26 |

[1] $CeO_2$ available from Byk under the tradename NanoByk 3810
[2] $CeO_2/SiO_2$ core shell particle obtained starting from Byk $CeO_2$ in Example 3 using $Na_2SiO_3$ as the silica precursor (targeted atom ratio Ce/Si = 1.39:1)
[3] $CeO_2$ available from Evonik as Ceria AdNano 60
[4] $CeO_2/SiO_2$ core shell particle obtained starting from Evonik $CeO_2$ using $Na_2SiO_3$ as the silica precursor (targeted atom ratio Ce/Si = 0.7:1)
[5] $CeO_2/SiO_2$ core shell particle obtained starting from Evonik $CeO_2$ using TEOS as the silica precursor (targeted atom ratio Ce/Si = 0.7:1)
[6] $TiO_2$ available from Sachtleben as Hombitec® 300 WP
[7] $TiO_2/SiO_2$ core shell particle obtained starting from Sachtleben $TiO_2$ using $Na_2SiO_3$ as the silica precursor (targeted atom ratio Ti/Si = 0.83:1)
* Comparative example

The results clearly show the tremendous improvement in transparency and haze obtainable with the core/shell particles compared to the particles having no core/shell structure.

The Yellowness index stability in the compositions in accordance with the instant invention was also markedly superior over the prior art compositions.

Should the disclosure of any patents, patent applications, and publications which are incorporated herein by reference conflict with the description of the present application to the extent that it may render a term unclear, the present description shall take precedence.

## Claims

**1.** Polymer compositions comprising

a) at least 10 wt%, based on the combined weight of components a) and b), of a polymer selected from the

group consisting of polyarylene polyethers having recurring units of the general formula I

$$\left[ X_1 - (E-(A)_o)_n - (X_2)_r - (E'-(A')_p)_m \right] \qquad (I)$$

wherein

$X_1$ is -O- or -S-,
$X_2$ is -O- or -S-
E and E' are the same or different and represent arylene groups containing 6 to 24 carbon atoms,
A and A' are the same or different and represent a mono-substituted 1,4-phenylene of the general formula

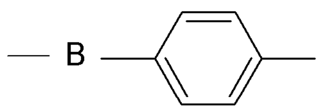

wherein B is O, S, $CH_2$, $C(CH_3)_2$, $C(CF_3)_2$, $SO_2$ or CO,
n and m are independently an integer of from 1 to 3,
o and p are 0, 1 or 2, and
r is 0 or 1,
polyimides comprising recurring units including at least one or more aromatic ring and one or more imide groups II as such or in their amic acid form

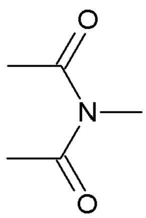

(II)

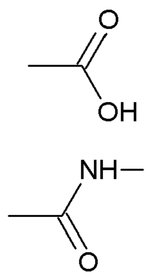

(II')

or a halogenated polymer, and

b) 0.1 wt% to 100 wt%, based on the weight of a), of at least one core/shell particle comprising

b1) at least one core comprising at least one inorganic compound C1 comprising at least one metal M1, and
b2) a shell comprising at least one inorganic compound C2 comprising at least one metal M2
wherein
the compounds C1 are selected from the group of oxides, oxyfluorides, oxyhydroxyfluorides and mixtures thereof,
the compounds C2 are, independently from the compounds C1, selected from the group consisting of oxides, fluorides, oxyfluorides, oxyhydroxyfluorides and mixtures thereof,

the metal M1 is selected from the group consisting of Zn, Ti, Zr, Ce or mixtures thereof
the metal M2 is selected from the group consisting of Si, Mg, Ca, Sr and mixtures thereof,
the molar ratio of the metal M1 in the core to the metal M2 in the shell is in the range of from 0.1:1 to 1.7:1, and
the average particle diameter of the core shell particles is less than or equal to 300 nm.

**2.** Polymer compositions in accordance with claim 1 wherein the polymer a) is a polyimide comprising recurring units of the formula III or III'

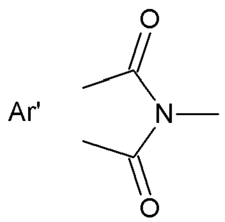 (III) 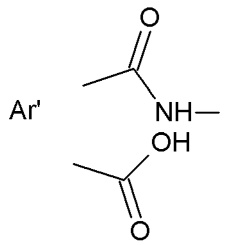 (III')

wherein Ar' denotes a moiety containing at least one aromatic ring.

**3.** Polymer compositions in accordance with claim 1 wherein the polymer a) is a poly(arylether sulfone).

**4.** Polymer compositions in accordance with claim 3 wherein the poly(arylether sulfone) is a polyphenylsulfone.

**5.** Polymer compositions in accordance with claim 1 wherein the polymer a) is a halogenated polymer.

**6.** Polymer compositions in accordance with claim 5 wherein the halogenated polymer is a vinylidene chloride homo- or copolymer.

**7.** Polymer compositions in accordance with claim 5, wherein the halogenated polymer is a per(halo)fluoropolymer.

**8.** Polymer compositions in accordance with any of claims 1 to 7 wherein the core/shell particle comprises at least one core comprising at least one inorganic compound C1 composed of at least one metal M1, at least one element E1 and, optionally, at least one metal M1', wherein the metal M1 is selected from the group consisting of Zn, Ti, Zr, Ce and mixtures thereof, said element E1 is selected from the group consisting of oxygen, fluorine, hydrogen and mixtures thereof and said metal M1' is any metal other than the metals M1.

**9.** Polymer compositions in accordance with any of claims 1 to 8 wherein the core shell particle comprises a shell comprising at least one inorganic compound C2 composed of at least one metal M2, at least one element E2 and, optionally, at least one metal M2', wherein the metal M2 is selected from the group consisting of Si, Mg, Ca, Sr and mixtures thereof, said element E2 is selected from the group consisting of oxygen, fluorine, hydrogen and mixtures thereof and said metal M2' is any metal other than the metals M2.

**10.** Polymer compositions in accordance with any of claims 1 to 9 wherein the metal M1' is present in compound C1.

**11.** Polymer compositions in accordance with any of claims 1 to 10 wherein the metal M2' is present in compound C2.

**12.** Polymer compositions in accordance with any of claims 1 to 11 wherein metal M1' is present in a compound C1', said compound C1' being composed of at least one metal M1' and at least one element E1', wherein E1' is selected from the group consisting of oxygen, fluorine, hydrogen and mixtures thereof.

**13.** Polymer compositions in accordance with any of claims 1 to 12 wherein metal M2' is present in a compound C2', said compound C2' being composed of at least one metal M2' and at least one element E2', wherein E2' is selected from the group consisting of oxygen, fluorine, hydrogen and mixtures thereof.

**14.** Polymer compositions in accordance with any of claims 1 to 13 wherein the core/shell particles b) are coated and/or grafted.

**15.** Photovoltaic module comprising a polymer composition in accordance with any of claims 1 to 14.

**Patentansprüche**

**1.** Polymerzusammensetzungen, umfassend

a) mindestens 10 Gew.-%, bezogen auf das kombinierte Gewicht der Komponenten a) und b), eines Polymers aus der Gruppe bestehend aus Polyarylenpolyethern mit Wiederholungseinheiten der allgemeinen Formel I

$$\left[ X_1 - (E-(A)_o)_n - (X_2)_r - (E'-(A')_p)_m \right] \quad (I)$$

worin

$X_1$ für -O- oder -S- steht,
$X_2$ für -O- oder -S- steht,
E und E' gleich oder verschieden sind und für Arylengruppen mit 6 bis 24 Kohlenstoffatomen stehen,
A und A' gleich oder verschieden sind und für ein monosubstituiertes 1,4-Phenylen der allgemeinen Formel

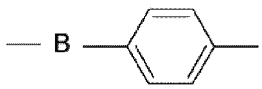

worin B für O, S, $CH_2$, $C(CH_3)_2$, $C(CF_3)_2$, $SO_2$ oder CO steht, stehen,
n und m unabhängig für eine ganze Zahl von 1 bis 3 stehen,
o und p für 0, 1 oder 2 stehen und
r für 0 oder 1 steht,
Polyimiden, umfassend Wiederholungseinheiten mit mindestens einem oder mehreren aromatischen Ringen und einer oder mehreren Imidgruppen II als solchen oder in ihrer Amidsäureform

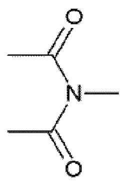

(II)

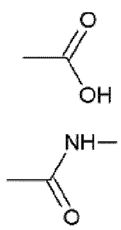

(II')

oder einem halogenierten Polymer und

b) 0,1 Gew.-% bis 100 Gew.-%, bezogen auf das Gewicht von a), mindestens eines Kern/Schale-Partikels, umfassend

b1) mindestens einen Kern, umfassend mindestens eine anorganische Verbindung C1, die mindestens ein

Metall M1 umfasst, und
b2) eine Schale, umfassend mindestens eine anorganische Verbindung C2, die mindestens ein Metall M2 umfasst,
wobei
die Verbindungen C1 aus der Gruppe von Oxiden, Oxidfluoriden, Oxidhydroxidfluoriden und Mischungen davon ausgewählt sind,
die Verbindungen C2 unabhängig von den Verbindungen C1 aus der Gruppe von Oxiden, Fluoriden, Oxidfluoriden, Oxidhydroxidfluoriden und Mischungen davon ausgewählt sind,
das Metall M1 aus der Gruppe bestehend aus Zn, Ti, Zr, Ce oder Mischungen davon ausgewählt ist,
das Metall M2 aus der Gruppe bestehend aus Si, Mg, Ca, Sr und Mischungen davon ausgewählt ist,
das Molverhältnis von Metall M1 in dem Kern zu Metall M2 in der Schale im Bereich von 0,1:1 bis 1,7:1 liegt und
der durchschnittliche Teilchendurchmesser der Kern-Schale-Partikel kleiner gleich 300 nm ist.

**2.** Polymerzusammensetzungen nach Anspruch 1, wobei es sich bei dem Polymer a) um ein Polyimid, das Wiederholungseinheiten der Formel III oder III'

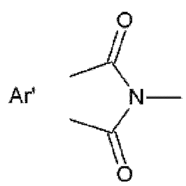 (III) 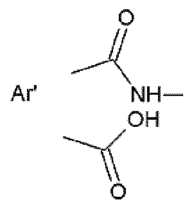 (III')

worin Ar' für eine Gruppierung mit mindestens einem aromatischen Ring steht, umfasst, handelt.

**3.** Polymerzusammensetzungen nach Anspruch 1, wobei es sich bei dem Polymer a) um ein Poly(arylethersulfon) handelt.

**4.** Polymerzusammensetzungen nach Anspruch 3, wobei es sich bei dem Poly(arylethersulfon) um Polyphenylsulfon handelt.

**5.** Polymerzusammensetzungen nach Anspruch 1, wobei es sich bei dem Polymer a) um ein halogeniertes Polymer handelt.

**6.** Polymerzusammensetzungen nach Anspruch 5, wobei es sich bei dem halogenierten Polymer um ein Vinylidenchlorid-Homopolymer oder -Copolymer handelt.

**7.** Polymerzusammensetzungen nach Anspruch 5, wobei es sich bei dem halogenierten Polymer um ein Per(halogen)fluorpolymer handelt.

**8.** Polymerzusammensetzungen nach einem der Ansprüche 1 bis 7, wobei das Kern/Schale-Partikel mindestens einen Kern, umfassend mindestens eine anorganische Verbindung C1, die aus mindestens einem Metall M1, mindestens einem Element E1 und gegebenenfalls mindestens einem Metall M1' besteht, umfasst, wobei das Metall M1 aus der Gruppe bestehend aus Zn, Ti, Zr, Ce und Mischungen davon ausgewählt ist, das Element E1 aus der Gruppe bestehend aus Sauerstoff, Fluor, Wasserstoff und Mischungen davon ausgewählt ist und es sich bei dem Metall M1' um ein beliebiges Metall, das von den Metallen M1 verschieden ist, handelt.

**9.** Polymerzusammensetzungen nach einem der Ansprüche 1 bis 8, wobei das Kern-Schale-Partikel eine Schale, umfassend mindestens eine anorganische Verbindung C2, die aus mindestens einem Metall M2, mindestens einem Element E2 und gegebenenfalls mindestens einem Metall M2' besteht, umfasst, wobei das Metall M2 aus der Gruppe bestehend aus Si, Mg, Ca, Sr und Mischungen davon ausgewählt ist, das Element E2 aus der Gruppe bestehend aus Sauerstoff, Fluor, Wasserstoff und Mischungen davon ausgewählt ist und es sich bei dem Metall M2' um ein beliebiges Metall, das von den Metallen M2 verschieden ist, handelt.

**10.** Polymerzusammensetzungen nach einem der Ansprüche 1 bis 9, wobei das Metall M1' in Verbindung C1 vorliegt.

**11.** Polymerzusammensetzungen nach einem der Ansprüche 1 bis 10, wobei das Metall M2' in Verbindung C2 vorliegt.

**12.** Polymerzusammensetzungen nach einem der Ansprüche 1 bis 11, wobei das Metall M1' in einer Verbindung C1' vorliegt, wobei die Verbindung C1' aus mindestens einem Metall M1' und mindestens einem Element E1' besteht, wobei E1' aus der Gruppe bestehend aus Sauerstoff, Fluor, Wasserstoff und Mischungen davon ausgewählt ist.

**13.** Polymerzusammensetzungen nach einem der Ansprüche 1 bis 12, wobei das Metall M2' in einer Verbindung C2' vorliegt, wobei die Verbindung C2' aus mindestens einem Metall M2' und mindestens einem Element E2' besteht, wobei E2' aus der Gruppe bestehend aus Sauerstoff, Fluor, Wasserstoff und Mischungen davon ausgewählt ist.

**14.** Polymerzusammensetzungen nach einem der Ansprüche 1 bis 13, wobei die Kern/Schale-Partikel b) beschichtet und/oder gepfropft sind.

**15.** Photovoltaikmodul, umfassend eine Polymerzusammensetzung nach einem der Ansprüche 1 bis 14.

## Revendications

**1.** Compositions polymères comprenant

a) au moins 10 % en poids, rapporté au poids combiné des composants a) et b), d'un polymère choisi dans le groupe constitué par les polyéthers de polyarylène ayant des motifs récurrents de la formule générale I

$$\{x_1 - (E-(A)_o)_n - (x_2)_r - (E'-(A')_p)_m\} \qquad (I)$$

dans laquelle

$X_1$ est -O- ou -S-,
$X_2$ est -O- ou -S-,
E et E' sont identiques ou différents et représentent des groupes arylène contenant 6 à 24 atomes de carbone,
A et A' sont identiques ou différents et représentent un 1,4-phénylène monosubstitué de la formule générale

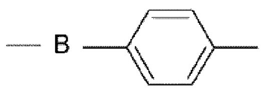

dans laquelle B est O, S, $CH_2$, $C(CH_3)_2$, $C(CF_3)_2$, $SO_2$ ou CO,
n et m sont indépendamment un entier de 1 à 3,
o et p valent 0, 1 ou 2, et
r vaut 0 ou 1,
les polyimides comprenant des motifs récurrents comportant au moins un ou plusieurs cycles aromatiques et un ou plusieurs groupes imide II tels quels ou sous leur forme d'acide amique

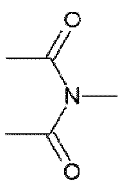

(II)

ou un polymère halogéné, et

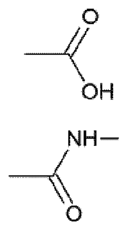

(II')

b) 0,1 % en poids à 100 % en poids, rapporté au poids de a), d'au moins une particule coeur/coquille comprenant

b1) au moins un coeur comprenant au moins un composé inorganique C1 comprenant au moins un métal M1, et
b2) une coquille comprenant au moins un composé inorganique C2 comprenant au moins un métal M2, dans lesquels
les composés C1 sont choisis dans le groupe des oxydes, oxyfluorures, oxyhydroxyfluorures et mélanges de ceux-ci,
les composés C2 sont, indépendamment des composés C1, choisis dans le groupe constitué par les oxydes, les fluorures, les oxyfluorures, les oxyhydroxyfluorures et les mélanges de ceux-ci,
le métal M1 est choisi dans le groupe constitué par Zn, Ti, Zr, Ce ou les mélanges de ceux-ci,
le métal M2 est choisi dans le groupe constitué par Si, Mg, Ca, Sr et les mélanges de ceux-ci,
le rapport molaire du métal M1 dans le coeur au métal M2 dans la coquille se situe dans la gamme de 0,1:1 à 1,7:1, et
le diamètre de particule moyen des particules coeur/ coquille est inférieur ou égal à 300 nm.

**2.** Compositions polymères selon la revendication 1 dans lesquelles le polymère a) est un polyimide comprenant des motifs récurrents de la formule III ou III'
dans lesquelles Ar' désigne une fraction contenant au moins un cycle aromatique.

**3.** Compositions polymères selon la revendication 1 dans lesquelles le polymère

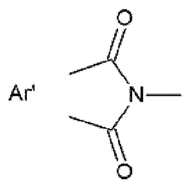

(III)

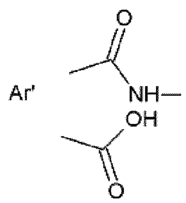

(III')

a) est une poly(aryléthersulfone).

**4.** Compositions polymères selon la revendication 3 dans lesquelles la poly(aryléthersulfone) est une polyphénylsulfone.

**5.** Compositions polymères selon la revendication 1 dans lesquelles le polymère a) est un polymère halogéné.

**6.** Compositions polymères selon la revendication 5 dans lesquelles le polymère halogéné est un homo - ou copolymère de chlorure de vinylidène.

**7.** Compositions polymères selon la revendication 5 dans lesquelles le polymère halogéné est un per(halogéno)fluoropolymère.

**8.** Compositions polymères selon l'une quelconque des revendications 1 à 7 dans lesquelles la particule coeur/ coquille comprend au moins un coeur comprenant au moins un composé inorganique C1 constitué d'au moins un métal M1, au moins un élément E1 et, optionnellement, au moins un métal M1', le métal M1 étant choisi dans le groupe constitué par Zn, Ti, Zr, Ce et les mélanges de ceux-ci, ledit élément E1 étant choisi dans le groupe constitué par l'oxygène, le fluor, l'hydrogène et les mélanges de ceux-ci et ledit métal M1' étant n'importe quel métal à part les métaux M1.

**9.** Compositions polymères selon l'une quelconque des revendications 1 à 8 dans lesquelles la particule coeur/ coquille comprend une coquille comprenant au moins un composé inorganique C2 constitué d'au moins un métal M2, au moins un élément E2 et, optionnellement, au moins un métal M2', le métal M2 étant choisi dans le groupe constitué par Si, Mg, Ca, Sr et les mélanges de ceux-ci, ledit élément E2 étant choisi dans le groupe constitué par l'oxygène, le fluor, l'hydrogène et les mélanges de ceux-ci et ledit métal M2' étant n'importe quel métal à part les métaux M2.

**10.** Compositions polymères selon l'une quelconque des revendications 1 à 9 dans lesquelles le métal M1' est présent dans le composé C1.

**11.** Compositions polymères selon l'une quelconque des revendications 1 à 10 dans lesquelles le métal M2' est présent dans le composé C2.

**12.** Compositions polymères selon l'une quelconque des revendications 1 à 11 dans lesquelles le métal M1' est présent dans un composé C1', ledit composé C1' étant constitué d'au moins un métal M1' et au moins un élément E1', E1' étant choisi dans le groupe constitué par l'oxygène, le fluor, l'hydrogène et les mélanges de ceux-ci.

**13.** Compositions polymères selon l'une quelconque des revendications 1 à 12 dans lesquelles le métal M2' est présent dans un composé C2', ledit composé C2' étant constitué d'au moins un métal M2' et au moins un élément E2', E2' étant choisi dans le groupe constitué par l'oxygène, le fluor, l'hydrogène et les mélanges de ceux-ci.

**14.** Compositions polymères selon l'une quelconque des revendications 1 à 13 dans lesquelles les particules coeur/coquille b) sont enrobées et/ou greffées.

**15.** Module photovoltaïque comprenant une composition polymère selon l'une quelconque des revendications 1 à 14.

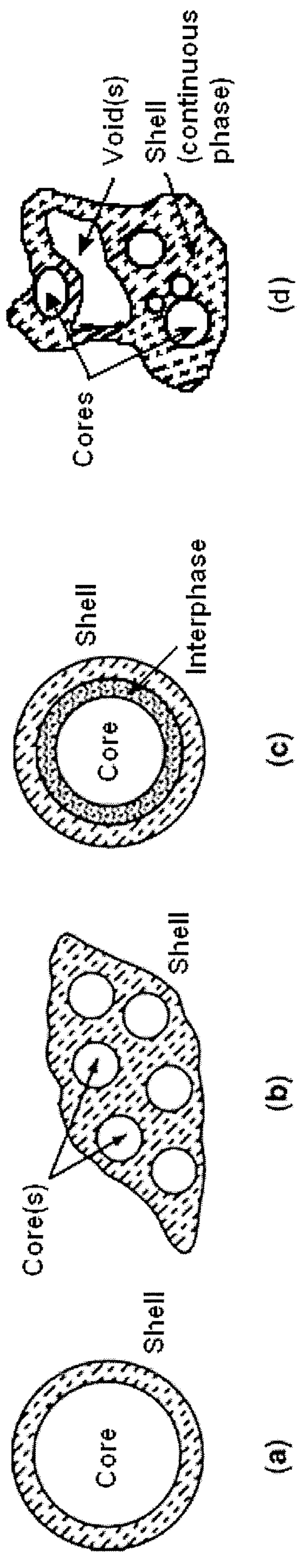
Core
Shell
(a)
Core(s)
Shell
(b)
Core
Shell
Interphase
(c)
Cores
Void(s)
Shell
(continuous
phase)
(d)

Figure 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 10157972 A
- WO 2008019905 A
- JP 2003292818 A
- JP 2002182424 A
- DE 10131173
- DE 10164904
- US 7371275 B
- US 2003186634 A
- WO 2003104319 A
- US 4065437 A
- US 4108837 A
- US 4175175 A
- US 4839435 A
- US 5434224 A
- US 6229970 A
- US 4029868 A
- US 5677404 A
- US 5703185 A
- US 5688885 A
- WO 03104319 A


### Non-patent literature cited in the description


- **MARK S.M. ALGER.** Polymer Science Dictionary. Elsevier Applied Science, 1989
- *Langmuir,* 2003, vol. 19, 6993-7000
- *Adv. Funct. Mat.,* 2004, vol. 14, 1089-1095
- **KALELE et al.** *Current Sci.,* 2006, vol. 91 (8
- **ATOU et al.** *Physica E,* 2003, vol. 16, 179-189
- **SIDDIQUEY et al.** *Applied surface sci.,* 2008, vol. 255, 2419-2424